# EUROPEAN PATENT SPECIFICATION

(11) **EP 2 686 326 B1**
(45) Date of publication and mention of the grant of the patent: **03.12.2014**
(21) Application number: 12709628.7
(22) Date of filing: 16.03.2012
(51) Int. Cl.: C07F 5/02, C07F 5/05, H01L 51/00

(54) **BORAZENE DERIVATIVES**
BORAZOLDERIVATE
DÉRIVÉS DE BORAZÈNE

(30) Priority: 18.03.2011 EP 11158909
(43) Date of publication of application: 22.01.2014
(73) Proprietor: Université de Namur, 5000 Namur (BE)
(72) Inventor: BONIFAZI, Davide, I-42016 Guastalla - Reggio Emilia (IT); KERVYN DE MEERENDRE, Simon, B-1367 Autre-eglise (BE)
(74) Representative: Pronovem
(86) International application number: PCT/EP2012/054689
(87) International publication number: WO 2012/126842

(56) References cited:
- JP-A- 2010 280 637
- US-A1- 2005 153 164
- PAETZOLD ET AL: "Boron imides in the thermal decomposition of diarylazidoboranes", CHEMISCHE BERICHTE, VERLAG CHEMIE GMBH. WEINHEIM, DE, vol. 116, no. 4, 1 January 1983 (1983-01-01), pages 1531-1539, XP002119538, ISSN: 0009-2940
- J. BIELAWSKI ET AL: "Boron-nitrogen compounds. 111. Reactions of borazines with pyrazole and related studies: (.mu.-amido)(.mu.-pyrazolato)diboron species, novel relatives of the pyrazaboles", INORGANIC CHEMISTRY, vol. 25, no. 26, 1 December 1986 (1986-12-01), pages 4623-4628, XP055007858, ISSN: 0020-1669, DOI: 10.1021/ic00246a006
- PINCKNEY M. JOHNSON ET AL: "Atropisomerism in aryl-substituted borazines", INORGANIC CHEMISTRY, vol. 13, no. 11, 1 November 1974 (1974-11-01), pages 2769-2772, XP055007898, ISSN: 0020-1669, DOI: 10.1021/ic50141a047
- DATABASE CA [Online] CHEMICAL ABSTRACTS SERVICE, COLUMBUS, OHIO, US; KORSHAK, V. V. ET AL: "Reaction of 1,2-diphenyldiborane with amines and organo-borodiamines", XP002659842, retrieved from STN Database accession no. 1963:482308 & KORSHAK, V. V. ET AL: "Reaction of 1,2-diphenyldiborane with amines and organo-borodiamines", IZVESTIYA AKADEMII NAUK SSSR, SERIYA KHIMICHESKAYA , (9), 1645-8 CODEN: IASKA6; ISSN: 0002-3353, 1963,
- DATABASE CA [Online] CHEMICAL ABSTRACTS SERVICE, COLUMBUS, OHIO, US; GERRARD, W.: "The experimental approach to the preparation of applicable borazole polymers", XP002659843, retrieved from STN Database accession no. 1962:25695 & GERRARD, W.: "The experimental approach to the preparation of applicable borazole polymers", SCI MONOGRAPH , 13, 328-42 CODEN: SCIGAY; ISSN: 0583-9416, 1961,

## Description

### Technical field of the invention

The present invention is directed to new borazene derivatives and their use in the manufacture of electronic devices, in particular electroluminescent and semiconductor devices. More specifically, the present invention relates to new stable borazene derivatives comprising boron atoms substituted by aryl groups and to their use in one or more layers of an electroluminescent or a semiconductor device, in particular in the emissive layer of organic light-emitting devices (OLED).

### Background of the invention

With the general aim of reducing energy consumption through the planet, an important focus of research has been directed to organic and polymer electroluminescent materials which have emerged as valuable alternatives to the production of incandescent light. The ever-growing interest in the research and development of OLED has been mainly motivated by their extended use in flat panel display technology.

While many research groups have oriented their studies towards white light production, finding reliable and efficient UV light sources has appeared as being of high interest in various domains, such as optical storage, photocatalysis, sterilization and disinfection, and various surgical methods or medical treatments such as ophthalmic surgery or epilepsy treatment.

Production of UV light by organic materials is much more challenging than white light (Visible) production due to the very few organic molecules known to emit in the UV with a quantum yield acceptable for the production of light-emitting devices.

Whereas inorganic material-based LED emitting in the UV are known, the latter have several disadvantages compared to their organic counterparts. These disadvantages include, but are not limited to, non-tunability of the electronic density of the corresponding material, and broad UV emission due to the crystal lattice in which the inorganic emitter is formed.

In that context, borazine materials have recently emerged as a new class of promising materials with alleged high electron and hole mobility for applications in electroluminescent devices. In particular, WO 2005/068583 discloses borazine-containing material with allegedly high hole and electron mobility and thermal stability, which can allegedly be used in one or more layers of an electroluminescent device, including OLED or PLED devices. These devices are allegedly claimed to be capable of emitting light in the UV or visible regions.

JP2005-170857 discloses a series of B, B, B"-trianthryl-N,N,N"-triarylborazine derivatives and which are capable of emitting in the UV-Visible region with fairly high quantum yields. Although their potential utility as a core framework for organic electronic device applications has been evoked, it remains that the fluorescence properties of the corresponding derivatives is mainly due to the anthracenyl moieties which may considerably reduce the potential electronic fine-tuning properties of the disclosed borazine derivatives and interfere with the fluorescence originating from the borazine ring.

Meller et al. in "Fluoralkyl- und Fluorarylborazinderivate, 1.Mitt.", published in Monatshefte fuer Chemie (1966), 97(2), 619-32, pages 388-395, discloses merely the synthesis and IR spectra of various N-Fluoroalkyl- and B-Fluoroarylborazines, including B,B,B"-pentafluorophenyl-N,N,N"-triphenylborazine derivatives.

JP 2010 280637 provides an industrially advantageous method for producing a B-arylborazine useful for the uses such as an insulation membrane for a semiconductor, a barrier metal layer, etc.

Paetzold et al. in "Boron imides from the thermal decomposition of diarylazidoboranes", published in Chem. Ber. 1983, vol. 116, no. 4, pages 1531-1539 describes that diarylazidoboranes are thermolyzed either into diazadiboretidines or into borazines. The formation of boron imides as reaction intermediates is discussed.

J. Bielawski et al. in "Reactions of borazines with pyrazole and related studies: (µ-amido) (µ-pyrazolato)diboron species, novel relatives of the pyrazaboles", published in Inorg. Chem. 1986, vol. 25, no. 26, pages 4623-4628 describes the reaction of borazines, (-BRNR-)₃, with pyrazole, Hpz, and some related studies.

Pinckney M. Johnson et al. in "Atropisomerism in aryl-substituted borazines", published in Inorg. Chem. 1974, vol. 13, no. 11, pages 2769-2772 presents an aryl-substituted borazine in which the absence of coplanarity of the aromatic and borazine rings is demonstrated. It also reports atropisomerism in borazines.

Korshak, V. V. et al. describe a reaction of 1,2-diphenyldiborane with amines and organo-borodiamines, published in Izvestiya Akademii Nauk SSSR, Seriya Khimicheskaya (1963), (9), 1645-8.

Gerrard, W. in "The experimental approach to the preparation of applicable borazole polymers", published in SCI Monograph (1961), 13, 328-42 develops procedures for joining borazole rings together to yield polyborazoles.

US 2005/0153164 relates to materials containing one or more borazine rings are employed as materials for electroluminescent devices.

Without contesting advantages associated with the use of borazine derivative materials described in the art, there is still a need for new stable borazene derivatives with improved properties.

### Aims of the invention

It is an aim of the present invention to provide new air-stable borazene derivatives which are capable of emitting in the UV region.

Advantageously, the borazene derivatives according to the invention are capable of emitting in the UV region with high quantum yield.

Advantageously still, the borazene derivatives according to the invention have substituents which allow fine-tuning the electronic properties of the borazene derivatives. Yet advantageously, the electronic properties of the borazine derivatives not according to the invention are fine-tunable without interfering or perturbing whatsoever with the fluorescence/emission originating from the borazine ring.

It is still another advantage that the borazene derivatives of the invention possess high charge carrier mobility and are easy to synthesize, while providing excellent processability (such as e.g. solution processing, continuous printing) and excellent stability under atmospheric/ambient conditions.

Advantageously still, the borazene derivatives of the invention have excellent stability against hydrolysis.

Advantageously, the borazene derivatives according to the invention are suitable for use in the emissive layer of an electroluminescent device, in particular an organic light-emitting devices (OLED).

In addition, the borazene derivatives of the invention may find particularly advantageous use in the manufacture of other electronic devices, in particular semiconductor devices, and preferably in the manufacture of transistors owing to their excellent charge carrier transport properties.

Other aims of the invention will be immediately apparent to those skilled in the art from the following description.

### Summary of the invention

According to one aspect of the present invention, it is provided a borazene derivative having the formula (**III**): 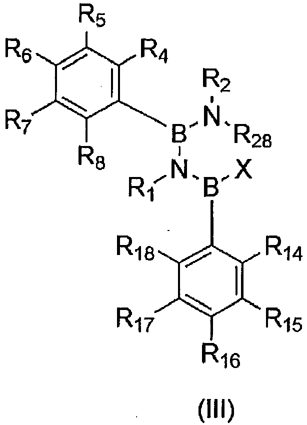 wherein the substituents R¹, R², R⁴ to R⁸, and R¹⁴ to R¹⁸ are the same or different from each other;
wherein each of R¹, R², R⁴ to R⁸, and R¹⁴ to R¹⁸ is independently selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbonyl group; carbamoyl group, arlyoxycarbonyl group, phenoxycarbonyl group, alkoxycarbonyl group and halogen; wherein R⁴, R⁸, R¹⁴ and R¹⁸ cannot simultaneously be selected to be hydrogen;
R⁴ to R⁸ and R¹⁴ to R¹⁸ cannot simultaneously be selected to be fluorine;
wherein R¹ and R² cannot simultaneously be selected to be methyl;
wherein R²⁸ is selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbobyl group; carbamoyl group, arlyoxycarbonykl group, phenoxycarbonyl group, alkoxycarbonyl group and halogen; and
wherein X is selected from the group consisting of: hydroxyl; alkoxy group; cycloalkyloxy group; aryloxy group; aralkyloxy group; acyloxy group; amino group; alkylamino group; cycloalkylamino group; dialkylamino group; arylamino group; aralkylamino group; diarylamino group; acylamino group;
wherein at least one substituent selected from the group of R⁶ and R¹⁶ is independently selected from the group consisting of linear or branched saturated alkyl groups, preferably with 1 to 6 carbon atoms, more preferably with 1 to 4 carbon atoms, even more preferably with 1 to 3 carbon atoms.

Preferably, in the derivative according to the invention, at least two substituents, preferably all the substituents selected from the group of R⁴, R⁸, R¹⁴ and R¹⁸ are independently selected from the group consisting of linear or branched saturated alkyl groups, preferably with 1 to 6 carbon atoms, more preferably with 1 to 4 carbon atoms, even more preferably with 1 to 3 carbon atoms.

Preferably, in the derivative according to the invention, each of R¹, R² and R²⁸ is independently selected from the group consisting of hydrogen, linear or branched saturated alkyl group, cycloalkyl group, aryl group and aralkyl group.

Preferably, in the borazene derivative according to the invention, X is selected from the group consisting of hydroxyl, alkoxy group, cycloalkyloxy group, aryloxy group, aralkyloxy group, amino group, alkylamino group, cycloalkylamino group, arylamino group and aralkylamino group; preferably from the group consisting of hydroxyl, alkylamino group, cycloalkylamino group, and arylamino group.

The present invention also concerns a method for the manufacture of an electronic device comprising the step of including a borazene derivative as disclosed hereabove, wherein the electronic device is preferably selected from the group consisting of electroluminescent and semiconductor devices.

Preferably, in the method according to the invention, the electronic device is a semiconductor device, preferably a transistor.

Another object of the present invention is the use of a borazene derivative as disclosed hereabove for the manufacture of an electronic device, preferably for the manufacture of a device selected from the group consisting of electroluminescent and semiconductor devices.

Preferably, in this use, the electronic device is an OLED, and the derivative is preferably used for the manufacture of the emissive layer of said OLED.

Preferably in this use, the electronic device is a semiconductor device, preferably a transistor.

According to another aspect, the present invention relates to an electronic device comprising at least one layer comprising a borazene derivative as described above, wherein the electronic device is preferably selected from the group consisting of electroluminescent and semiconductor devices.

In a preferred aspect, the electronic device of the invention is an OLED, wherein said layer is preferably the emissive layer.

In another preferred aspect, the electronic device of the invention is a semiconductor device. More preferably, the electronic device of the invention is a transistor.

Preferably, the derivative according to the invention is able to emit in the UV region with a quantum yield above 0.05, preferably above 0.3, more preferably above 0.4, even more preferably above 0.5, most preferably above 0.6.

In the present description, the term "OLED" refers to organic light-emitting devices comprising an organic electroluminescent medium, with thickness of the order of about 100 nm, sandwiched between two electrodes. The most commonly used device configurations of OLED are of three different types: single layer type, double layer type and multilayer type. OLED of single layer type have only a single electroluminescent layer between the anode and the cathode. OLED of double layer type comprise two layers which are responsible for transporting holes and electrons, respectively. One of the hole-transporting layer or the electron-transporting layer is also the emitting layer. In a multilayer device, an emitting layer is inserted between the hole-transporting layer and the electron-transporting layer; said device may further comprise other layers, with other functionalities, such as hole-blocking layers, electron-blocking layers, and/or layers acting as "steps" to its adjacent layer.

In the present invention, providing electroluminescent devices with enhanced performances includes but is not limited to providing electroluminescent devices with high purity color, efficiency and low driving voltage.

Electroluminescent devices according to the invention, and in particular OLED, can be obtained by means of different techniques known by the man skilled in the art, in particular with vapor deposition, spin-coating, inkjet printing processes and the like.

### Brief description of the drawings

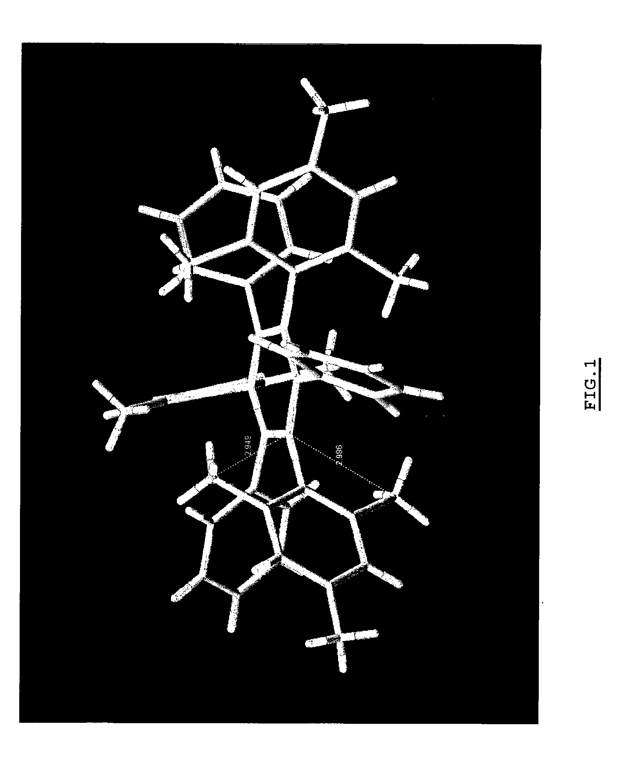

**Figure 1** represents the crystal structure of borazine derivative (**1**) not according to the invention showing the short carbon-boron distance, wherein the methyl groups are believed to protect the boron from a nucleophilic attack.
**Figure 2** represents UV absorption spectra of borazine derivative (**1**) not according to the invention showing the absorption maxima at 222 nm.
**Figure 3** represents the emission spectra of borazine derivative (**1**) not according to the invention in solution at 300nm.
**Figure 4** represents UV absorption spectra of borazene derivative (**3**) and borazene derivative (**4**) showing the absorption maxima at 200nm.
**Figure 5** represents the fluorescence spectra of borazene derivative **(3)** and borazene derivative (**4**) showing the emission maxima at 318nm.
**Figure 6** represents UV absorption spectra of borazene derivative (**5**) and borazene derivative (**6**) showing the absorption maxima at 200nm.
**Figure 7** represents the fluorescence spectra of borazene derivative (**5**) and borazene derivative (**6**) showing the emission maxima at 318nm.
**Figure 8** represents UV absorption spectra of borazene derivative (**7**) and borazene derivative (**8**) showing the absorption maxima at 200nm.
**Figure 9** represents the excitation spectra of borazene derivative (**7**) and borazene derivative (**8**) showing the emission maxima at 279nm.
**Figure 10** represents the emission spectra of borazene derivative (**7**) and borazene derivative (**8**) showing the emission maxima at 303nm.
**Figure 11** represents the general synthetic strategy for the formation of derivatives according to formula (**I**).
**Figure 12** represents the general synthetic strategy for the formation of borazine derivatives not according to the invention according to formula (**II**).

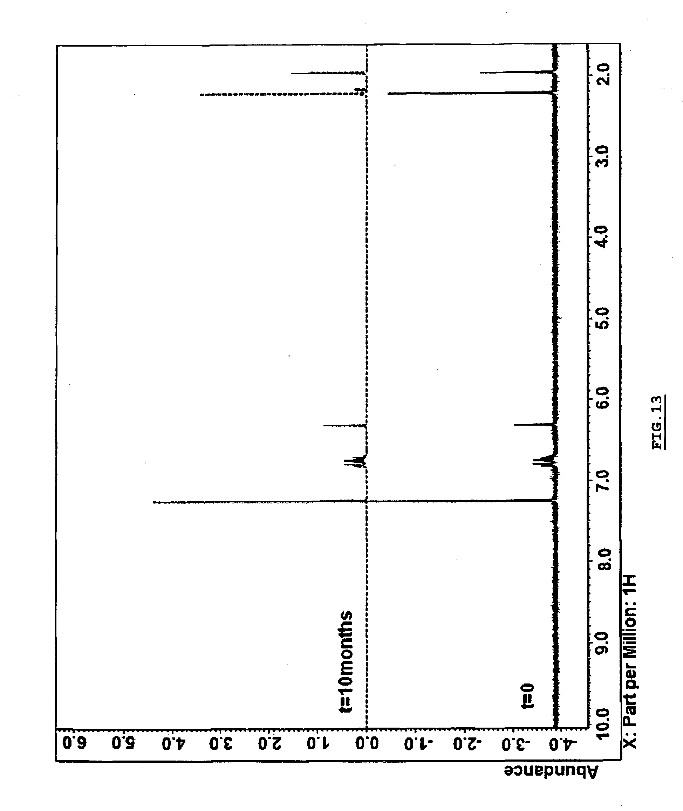

**Figure 13** represents the NMR spectra of borazine derivative (**1**) not according to the invention at t=0 (top) and at t=10 months (bottom) showing the excellent stability of the compound at air and room temperature.

### Detailed description of the invention

According to one aspect of the present invention, it is provided a derivative of the formula (I): 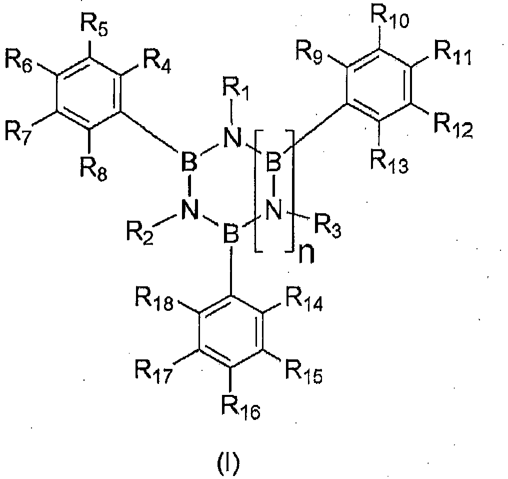 wherein the substituents R¹ to R¹⁶ are the same or different from each other;
wherein each of R¹ to R¹⁸ is independently selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbonyl group; carbamoyl group, arlyoxycarbonyl group, phenoxycarbonyl group, alkoxycarbonyl group and halogen;
wherein n=0;
wherein R⁴, R⁸, R⁹, R¹³, R¹⁴ and R¹⁸ cannot simultaneously be selected to be hydrogen;
wherein R⁴ to R⁸ and R¹⁴ to R¹⁸ cannot simultaneously be selected to be fluorine; and
wherein R¹, R² and R³ cannot simultaneously be selected to be methyl.

According to an aspect not according to the present invention, when n= 1, it is provided a (borazine) derivative having the formula (**Ia**):

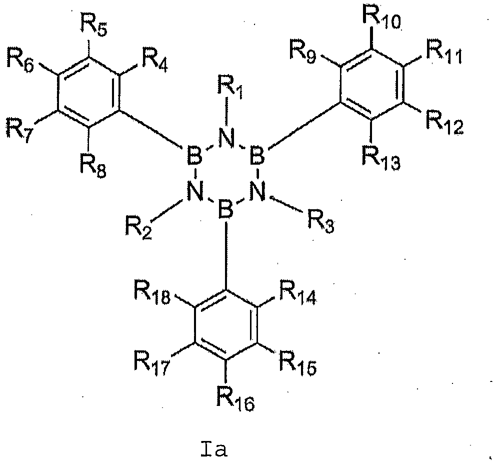

Preferably, in the derivative not according to the invention, when n=1, the (borazine) derivative has the formula (**II**): 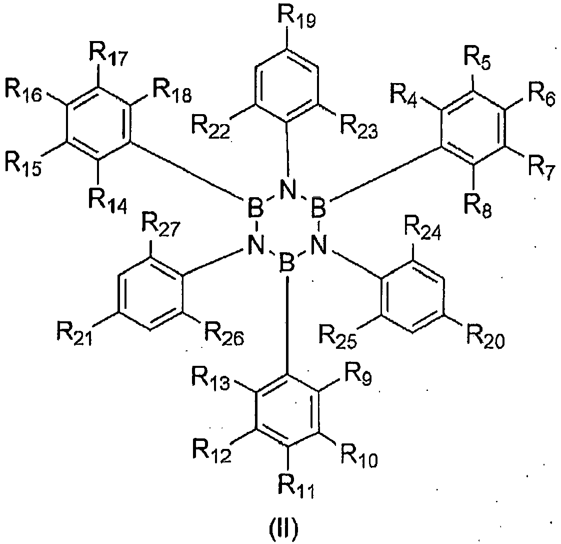 wherein the substituents R⁴ to R¹⁸ are as defined hereinabove; wherein the substituents R¹⁹ to R²⁷ are the same or different from each other; and
wherein each of R¹⁹ to R²⁷ is independently selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbobyl group; carbamoyl group, arlyoxycarbonykl group, phenoxycarbonyl group, alkoxycarbonyl group and halogen.

Preferably, in the (borazine) derivative not according to the invention as described above, at least one substituent, preferably all the substituents, selected from the group of R²², R²³, R²⁴, R²⁵, R²⁶ and R²⁷ are independently selected to be hydrogen.

In the derivative of the invention, when n=0, the (borazene) derivative has the formula **(III):** 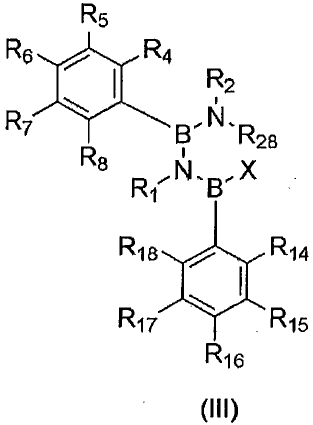 wherein the substituents R¹, R², R⁴ to R⁸, and R¹⁴ to R¹⁸ are as defined hereinabove;
wherein R²⁸ is selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbobyl group; carbamoyl group, arlyoxycarbonykl group, phenoxycarbonyl group, alkoxycarbonyl group and halogen; and
wherein X is selected from the group consisting of: hydroxyl; alkoxy group; cycloalkyloxy group; aryloxy group; aralkyloxy group; acyloxy group; amino group; alkylamino group; cycloalkylamino group; dialkylamino group; arylamino group; aralkylamino group; diarylamino group; acylamino group.

Preferably, in the (borazene or borazine) derivatives, at least two substituents, preferably all the substituents, selected from the group of R⁴, R⁶, R⁹, R¹³, R¹⁴ and R¹⁸ are independently selected from the group consisting of linear or branched saturated alkyl groups, preferably with 1 to 6 carbon atoms, more preferably with 1 to 4 carbon atoms, even more preferably with 1 to 3 carbon atoms. Still more preferably, in the (borazene or borazine) derivatives of the invention, at least two substituents, preferably all the substituents selected from the group of R⁴, R⁶, R⁹, R¹³, R¹⁴ and R¹⁸ are independently selected from the group consisting of methyl, ethyl, and isopropyl groups.

Preferably, in the (borazene or borazine) derivatives, at least one substituent, preferably all the substituents, selected from the group of R⁶, R¹¹ and R¹⁶ are independently selected from the group consisting of linear or branched saturated alkyl groups and halogens; preferably from the group consisting of linear or branched saturated alkyl groups with 1 to 6 carbon atoms, more preferably with 1 to 4 carbon atoms, even more preferably with 1 to 3 carbon atoms. Still more preferably, in the (borazene or borazine) derivatives, at least one substituent, preferably all the substituents, selected from the group of R⁶, R¹¹ and R¹⁶ are independently selected from the group consisting of methyl, ethyl and isopropyl groups.

Preferably, in the (borazine) derivatives not according to the invention, at least one substituent, preferably all the substituents, selected from the group of R¹⁹, R²⁰ and R²¹ are independently selected from the group consisting of hydrogen, and linear or branched saturated alkyl groups, preferably with 1 to 12 carbon atoms, more preferably with 1 to 6 carbon atoms, even more preferably with 1 to 3 carbon atoms. More preferably, in the (borazine) derivative not according to the invention, at least one substituent, preferably all the substituents, selected from the group of R¹⁹, R²⁰ and R²¹ are independently selected from the group consisting of hydrogen and dodecyl groups.

Preferably, in the (borazene or borazine) derivatives, each of R¹ to R³ is independently selected from the group consisting of hydrogen, linear or branched saturated alkyl group, cycloalkyl group, aryl group and aralkyl group. More preferably, in the (borazene or borazine) derivatives of the invention, each of R¹ to R³ is independently selected from the group consisting of hydrogen, isopropyl, cyclohexyl and phenyl groups.

Preferably, in the (borazene) derivatives of the invention, R²⁸ is selected from the group consisting of hydrogen, linear or branched saturated alkyl group, cycloalkyl group, aryl group and aralkyl group. More preferably, in the (borazene) derivative of the invention, R²⁸ is selected from the group consisting of hydrogen, isopropyl, cyclohexyl and phenyl groups.

Preferably, in the (borazene) derivatives of the invention, X is selected from the group consisting of hydroxyl, alkoxy group, cycloalkyloxy group, aryloxy group, aralkyloxy group, amino group, alkylamino group, cycloalkylamino group, arylamino group and aralkylamino group; preferably from the group consisting of hydroxyl, alkylamino group, cycloalkylamino group, and arylamino group. More preferably, in the (borazene) derivative of the invention, X is selected from the group consisting of hydroxyl, cyclohexylamino group, benzylamino group and isopropylamino group.

Preferably, the (borazine) derivative not according to the invention is according to formula (**II**), wherein R⁹, R⁶, R⁸, R⁹, R¹¹, R¹³, R¹⁴, R¹⁶ and R¹⁸ are methyl groups; and wherein R⁵, R⁷, R¹⁰, R¹², R¹⁵, R¹⁷ and R¹⁹ to R²⁷ are selected to be hydrogen.

Preferably, the (borazine) derivative not according to the invention is according to formula (**II**), wherein R⁴, R⁶, R⁸, R⁹, R¹¹, R¹³, R¹⁴, R¹⁶ and R¹⁸ are methyl groups; wherein R⁵, R⁷, R¹⁰, R¹², R¹⁵ and R¹⁷ and R²² to R²⁷ are selected to be hydrogen; and wherein R¹⁹, R²⁰, R²¹ are dodecyl groups.

Preferably, the (borazene) derivative of the invention is according to formula (**III**), wherein R¹ and R² are cyclohexyl groups; wherein R⁴, R⁶, R⁸, R¹⁴, R¹⁶ and R¹⁸ are methyl groups; wherein R⁵, R⁷, R¹⁵, R¹⁷ and R²⁸ are selected to be hydrogen; and wherein X is selected to be hydroxyl group.

Preferably, the (borazene) derivative of the invention is according to formula (**III**), wherein R¹ and R² are cyclohexyl groups; wherein R⁴, R⁶, R⁸, R¹⁴, R¹⁶ and R¹⁸ are methyl groups; wherein R⁵, R⁷, R¹⁵, R¹⁷ and R²⁸ are selected to be hydrogen; and wherein X is selected to be cyclohexylamino group.

Preferably, the (borazene) derivative of the invention is according to formula (**III**), wherein R¹ and R² are benzyl groups; wherein R⁴, R⁶, R⁸, R¹⁴, R¹⁶ and R¹⁸ are isopropyl groups; wherein R⁵, R⁷, R¹⁵, R¹⁷ and R²⁸ are selected to be hydrogen; and wherein X is selected to be hydroxyl group.

Preferably, the (borazene) derivative of the invention is according to formula (**III**), wherein R¹ and R² are benzyl groups; wherein R⁴, R⁶, R⁸, R¹⁴, R¹⁶ and R¹⁸ are isopropyl groups; wherein R⁵, R⁷, R¹⁵, R¹⁷ and R²⁸ are selected to be hydrogen; and wherein X is selected to be benzylamino group.

Preferably, the (borazene) derivative of the invention is according to formula (**III**), wherein R¹ and R² are isopropyl groups; wherein R⁴, R⁶, R⁸, R¹⁴, R¹⁶ and R¹⁸ are methyl groups; wherein R⁵, R⁷, R¹⁵, R¹⁷ and R²⁸ are selected to be hydrogen; and wherein X is selected to be hydroxyl group.

Preferably, the (borazene) derivative of the invention is according to formula (**III**), wherein R¹ and R² are isopropyl groups; wherein R⁴, R⁶, R⁸, R¹⁴, R¹⁶ and R¹⁶ are methyl groups; wherein R⁵, R⁷, R¹⁵, R¹⁷ and R²⁸ are selected to be hydrogen; and wherein X is selected to be isopropylamino group.

According to another aspect, the present invention relates to an electronic device comprising at least one layer comprising a (borazene) derivative as described above, wherein the electronic device is preferably selected from the group consisting of electroluminescent and semiconductor devices.

In a preferred aspect, the electronic device of the invention is an OLED, wherein said layer is preferably the emissive layer.

In another preferred aspect, the electronic device of the invention is a semiconductor device. More preferably, the electronic device of the invention is a transistor.

According to still another aspect of the present invention, it is provided a method for the manufacture of an electronic device which comprises the step of including a (borazene) derivative as described above, wherein the electronic device is preferably selected from the group consisting of electroluminescent and semiconductor devices.

Preferably, in the method of the present invention, the electronic device is an OLED. More preferably, in the method of the present invention the (borazene) derivative is included in the emissive layer of the OLED.

Preferably still, in the method of the present invention, the electronic device is a semiconductor device, more preferably a transistor.

According to still another aspect, the present invention relates to the use of a (borazene) derivative as described above for the manufacture of an electronic device. Preferably, the (borazene) derivative of the invention is used for the manufacture of a device selected from the group consisting of electroluminescent and semiconductor devices.

In a preferred aspect, the (borazene) derivative of the invention is used for the manufacture of an OLED, wherein the (borazene) derivative is preferably used for the manufacture of the emissive layer of the OLED.

In another preferred aspect, the (borazene) derivative of the invention is used for the manufacture of a semiconductor device, preferably a transistor.

According to one aspect of the present invention, it is provided a borazene derivative of the formula (I): 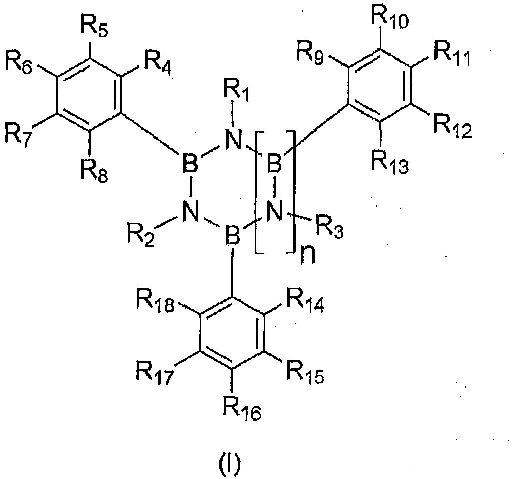 wherein the substituents R¹ to R¹⁸ are the same or different from each other;
wherein each of R¹ to R¹⁸ is independently selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbonyl group; carbamoyl group, arlyoxycarbonyl group, phenoxycarbonyl group, alkoxycarbonyl group and halogen;
wherein n=0;
wherein R⁴, R⁸, R⁹, R¹³, R¹⁴ and R¹⁸ cannot simultaneously be selected to be hydrogen;
wherein R⁴ to R⁸ and R¹⁴ to R¹⁸ cannot simultaneously be selected to be fluorine; and
wherein R¹, R² and R³ cannot simultaneously be selected to be methyl.

In the context of the present invention, it has been surprisingly found that the borazene derivatives according to the invention exhibit excellent stability to air, which includes resistance to oxidation, hydrolysis, degradation or decomposition under atmospheric/ambient conditions.

Without wishing to be bound by theory, it is believed that this excellent stability is due to the steric hindrance around the boron atoms created by the particular substituents depicted in formula (**I**) above. It is in particular believed that the presence of group substituents based on (substituted) phenyl moieties, as defined above, creates particularly efficient steric protection around the boron atoms of the borazene derivatives of the invention on which they are substituted.

Also, it is believed that the presence of at least one substituent in (preferably all) the ortho positions of the phenyl groups linked to the boron atoms of the borazene derivatives of the invention plays a substantial role in protecting the boron atoms against in particular nucleophilic attacks.

In some preferred aspects of the borazene derivatives of the invention, the particular substituents present on the nitrogen atoms may participate in creating further improved steric protection around the boron atoms of the borazene derivatives of the invention.

Preferably, in the derivative not according to the invention, when n=1, the borazine derivative has the formula (**II**): 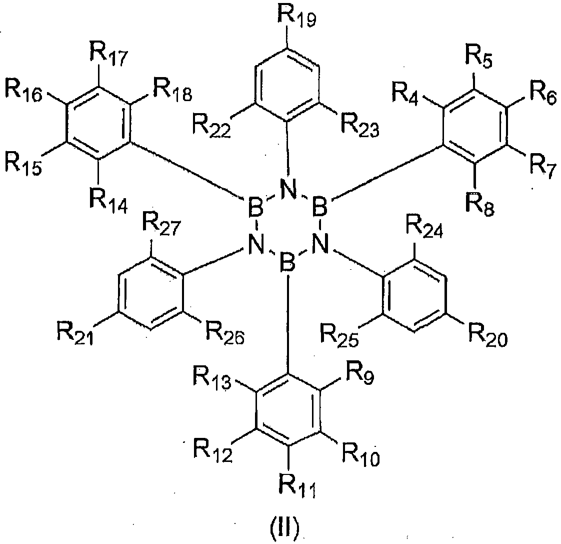 wherein the substituents R⁴ to R¹⁸ are as defined hereinabove; wherein the substituents R¹⁹ to R²⁷ are the same or different from each other; and
wherein each of R¹⁹ to R²⁷ is independently selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbobyl group; carbamoyl group, arlyoxycarbonykl group, phenoxycarbonyl group, alkoxycarbonyl group and halogen.

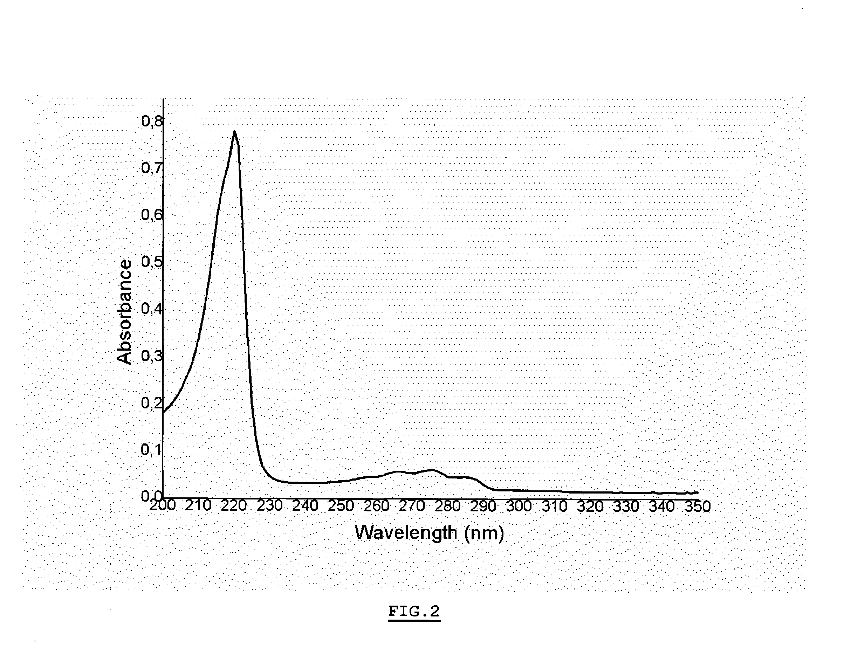

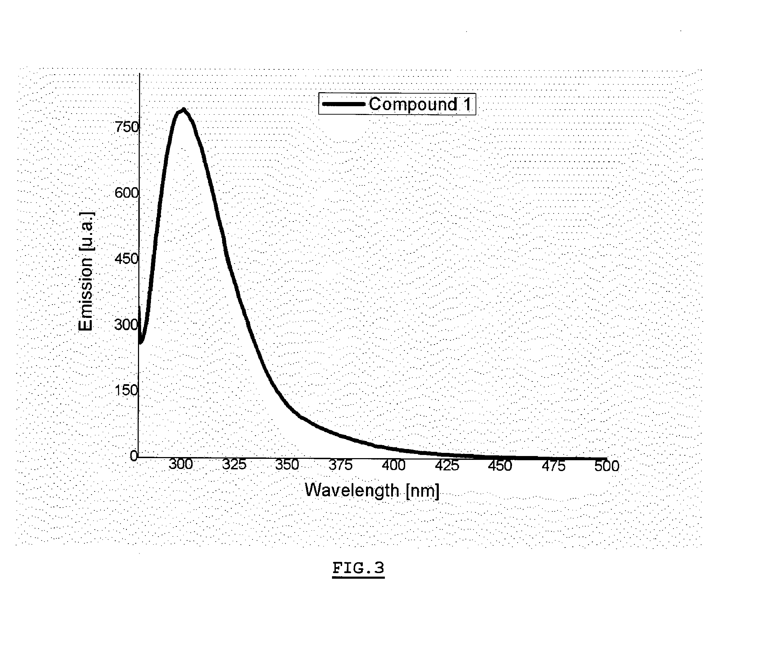

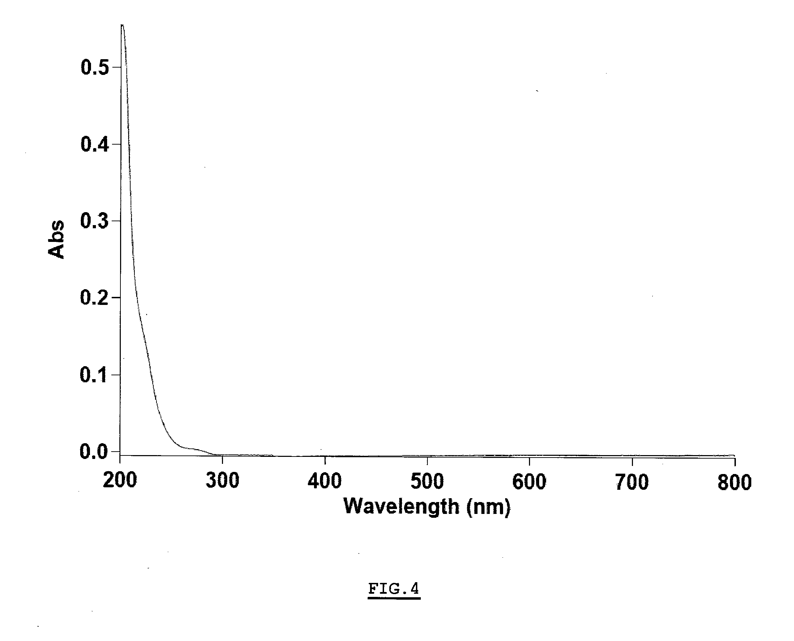

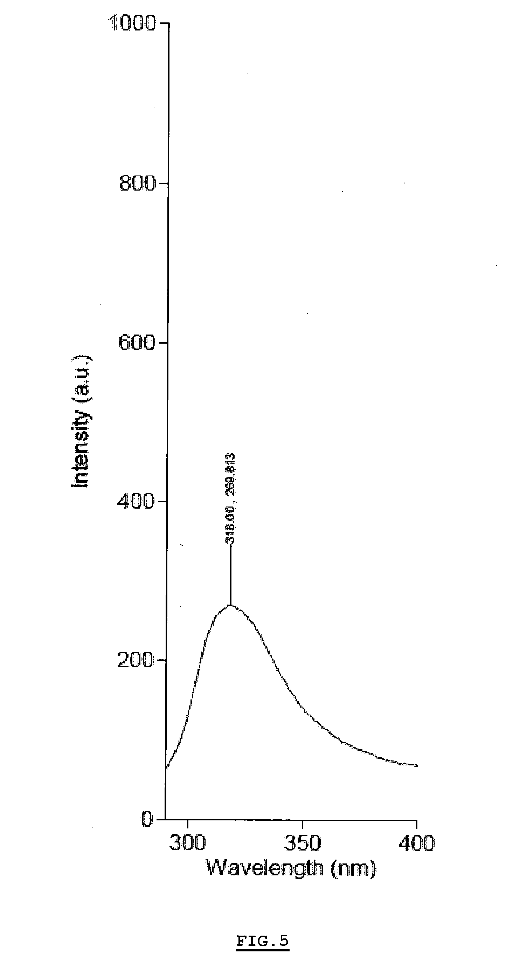

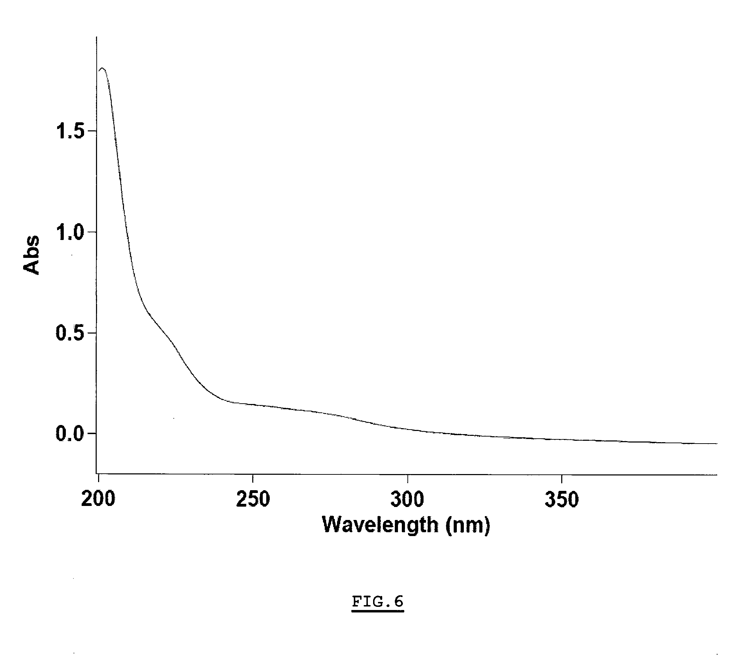

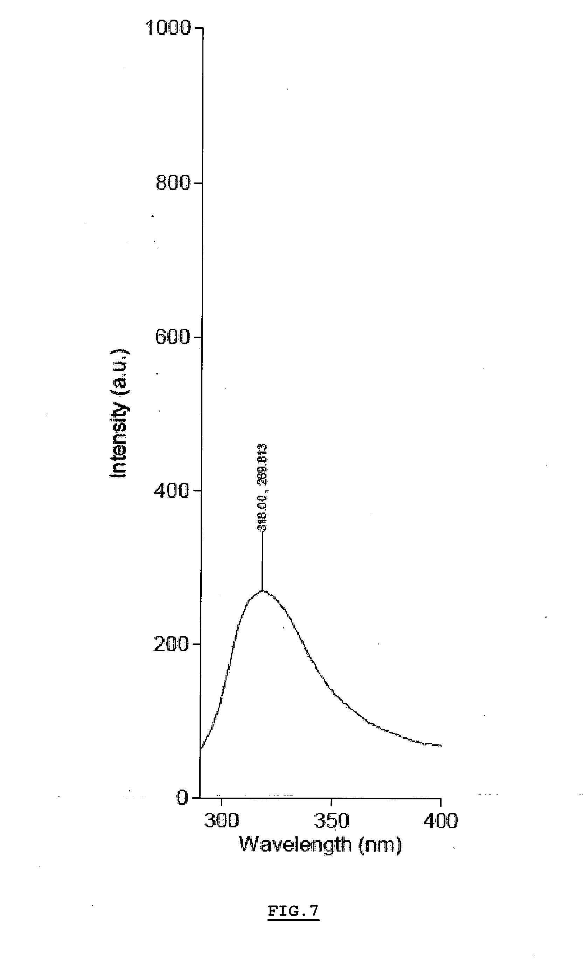

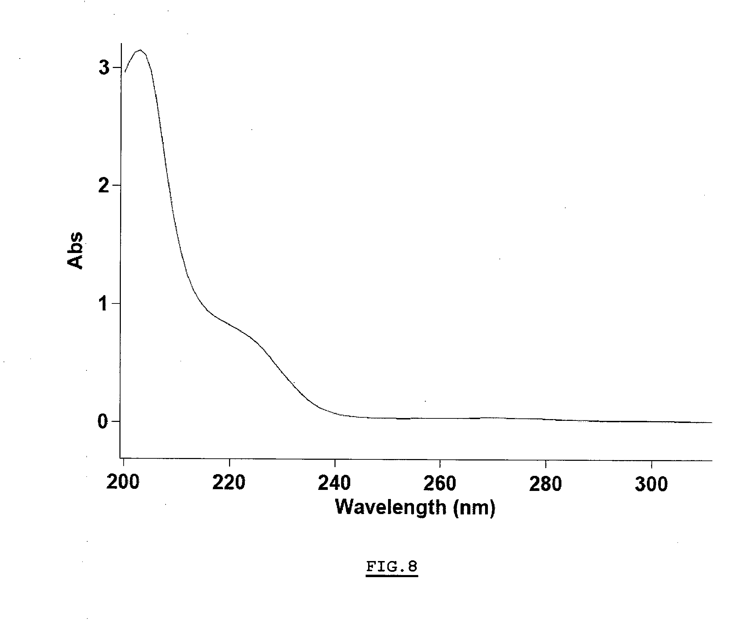

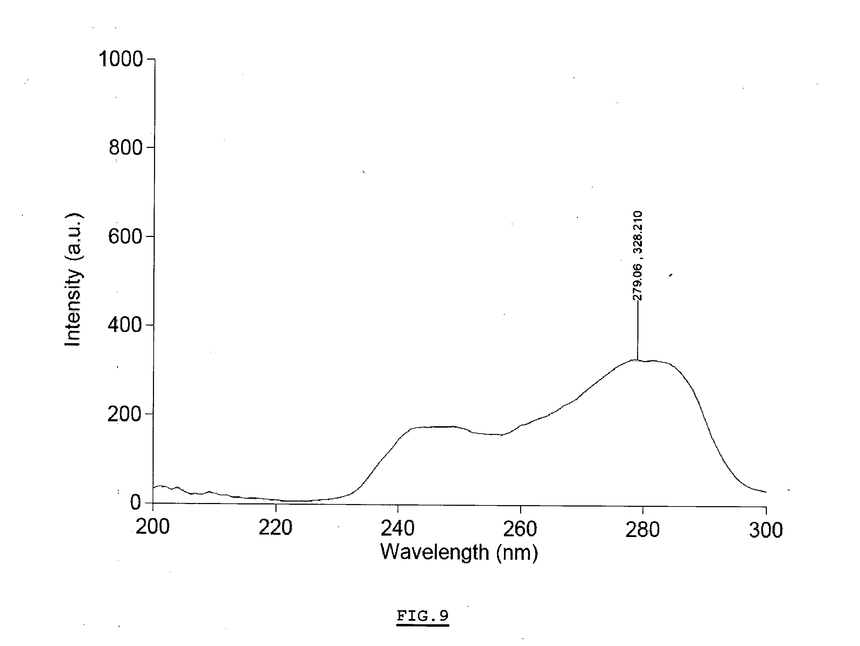

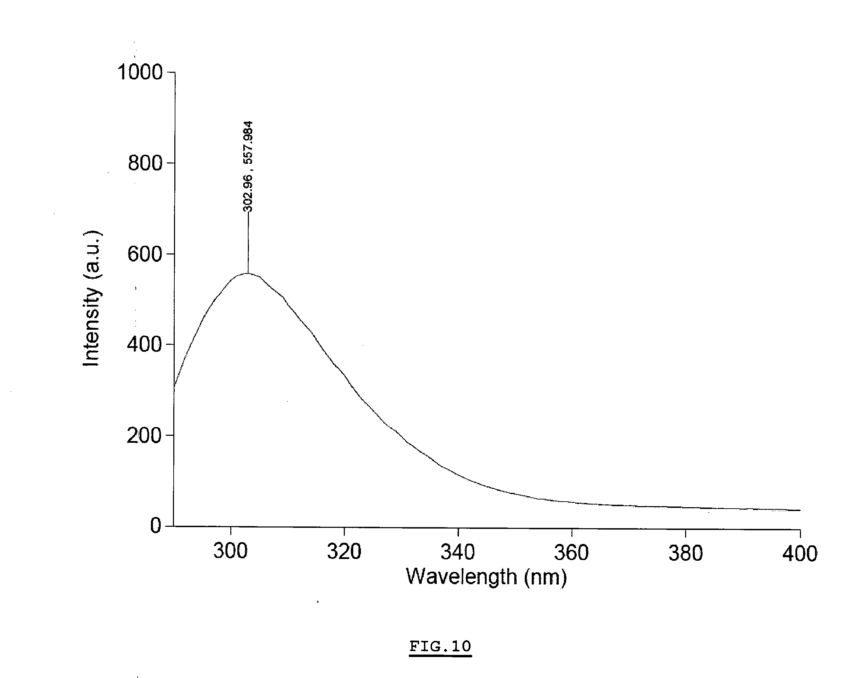

Borazene or borazine derivatives have been surprisingly found to emit in the UV region (typically in a region corresponding to a wavelength comprised between 100nm and 400 nm) as depicted in **FIG.2** to **FIG.10****.**

According to a preferred aspect, borazene derivatives according to the invention have the capability to emit (substantially) exclusively in the UV region and are substantially non-emissive in the visible region. This specific property will provide better emission control and color purity when such borazene derivatives are included in e.g. light-emitting devices.

However, some borazene derivatives according to the invention may be capable of additionally emitting (at least partially) in the UV-Visible region.

As previously mentioned, UV light sources may find particular use in various domains, such as optical storage, photocatalysis, sterilization and disinfection of liquids such as water or surgical tools, detection of counterfeiting products, and in various surgical methods or medical treatments such as ophthalmic surgery or epilepsy treatment.

Advantageously, the borazene derivatives according to the invention are capable of emitting (essentially in the UV region) with a surprisingly sharp emission peak. This property allows obtaining -UV light sources with very precise emission characteristics, which may be particularly useful in e.g. the field of water treatment/disinfection.

Advantageously, the borazene derivatives according to the invention are capable of emitting in the UV region with surprisingly high quantum yield. Typically, quantum yields of above 0.05, preferably above 0.3, more preferably above 0.4, even more preferably above 0.5, most preferably above 0.6. Quantum yields are typically measured in solution or in solid state.

Advantageously still, the borazene derivatives according to the invention have substituents which allow fine-tuning the electronic properties of the borazene derivatives. In that context, it has been surprisingly found that the borazene derivatives of the invention, by appropriate selection of the substituents linked to the borane and nitrogen atoms of the borazene derivatives, permits fine modulation of the fluorescence/emission properties while preserving emission in the UV region and stability to air, and whilst preserving high quantum yield of the emission.

In the case of borazine derivatives not according to the invention, this fine-tuning may be performed without detrimentally affecting (interfering or perturbing) the emission properties of the borazine ring per se. As such, the group substituents present in the borazine derivatives not according to the present invention may be formerly be regarded as "transparent substituents" since they provide minimum contribution to the overall UV emission of the borazine derivative, whereas the main contribution to the overall UV emission of the borazine derivatives may be attributed to the borazine ring. This is important property of the borazine derivatives not according to the invention which provides better control of the overall UV emission properties, and ultimately improved performance/efficiency of the luminescent devices manufactured with the borazine derivatives.

Advantageously, the borazene derivatives of the invention surprisingly provide excellent processability properties, and allow in particular solution processing and continuous printing (such as e.g. ink jet printing).

Still another surprising advantage of the borazene derivatives, in particular the borazene derivates, of the invention resides in the fact that they possess high charge carrier mobility, including excellent electron and hole mobility properties.

Accordingly, the borazene derivatives according to the invention may advantageously be used in the manufacture of electronic devices, preferably electroluminescent devices and semiconductor devices.

The borazine derivatives not according to the invention may find particular use in the manufacture of the emissive layer of the electroluminescent device, in particular an organic light-emitting device (OLED). The borazine derivatives not according to the invention may be used/incorporated in other typical layers of electroluminescent layers such as e.g, hole-injection layer, hole-transporting layer, electron-injection layer and electron-transporting layer.

The borazene derivatives of the invention may find particular use in the manufacture of semiconductor devices, preferably transistors.

Other applications of the borazene derivatives according to the invention include, but are not limited to, use as flame retardant, use as insulator for capacitors, use as hydrogen material, use for the production of ceramics, use in neutron therapy as neutron capture agent, and use in non-linear optical.

Preferably, in the borazine derivative not according to the invention as described above, at least one substituent, preferably all the substituents, selected from the group of R²², R²³, R²⁴, R²⁵, R²⁶ and R²⁷ are independently selected to be hydrogen.

In the derivative of the invention, when n=0, the borazene derivative has the formula (**III**): 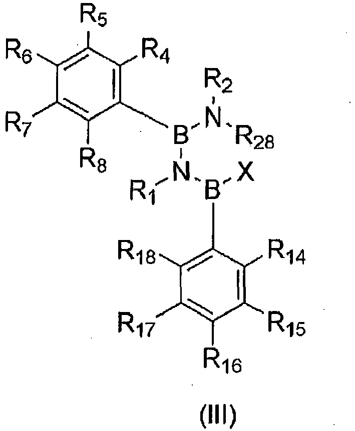 wherein the substituents R¹, R², R⁴ to R⁸, and R¹⁴ to R¹⁸ are as defined hereinabove;
wherein R²⁸ is selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbobyl group; carbamoyl group, arlyoxycarbonykl group, phenoxycarbonyl group, alkoxycarbonyl group and halogen; and
wherein X is selected from the group consisting of: hydroxyl; alkoxy group; cycloalkyloxy group; aryloxy group; aralkyloxy group; acyloxy group; amino group; alkylamino group; cycloalkylamino group; dialkylamino group; arylamino group; aralkylamino group; diarylamino group; acylamino group.

Preferably, in the borazene or borazine derivatives, at least two substituents, preferably all the substituents, selected from the group of R⁴, R⁸, R⁹, R¹³, R¹⁴ and R¹⁸ are independently selected from the group consisting of linear or branched saturated alkyl groups, preferably with 1 to 6 carbon atoms, more preferably with 1 to 4 carbon atoms, even more preferably with 1 to 3 carbon atoms. Exemplary linear or branched saturated alkyl groups for use herein include, but are not limited to, methyl, ethyl, n-propyl, iso-propyl, n-butyl, iso-butyl, tertio-butyl, pentyl and hexyl groups. Still more preferably, in the borazene or borazine derivatives, at least two substituents, preferably all the substituents, selected from the group of R⁴, R⁸, R⁹, R¹³, R¹⁴ and R¹⁸ are independently selected from the group consisting of methyl, ethyl, and isopropyl groups.

Preferably, in the borazene or borazine derivatives, at least one substituent, preferably all the substituents, selected from the group of R⁶, R¹¹ and R¹⁶ are independently selected from the group consisting of linear or branched saturated alkyl groups and halogens; preferably from the group consisting of linear or branched saturated alkyl groups with 1 to 6 carbon atoms, more preferably with 1 to 4 carbon atoms, even more preferably with 1 to 3 carbon atoms. Exemplary linear or branched saturated alkyl groups for use herein include, but are not limited to, methyl, ethyl, n-propyl, iso-propyl, n-butyl, iso-butyl, tertio-butyl, pentyl and hexyl groups. Still more preferably, in the borazene or borazine derivatives, at least one substituent, preferably all the substituents, selected from the group of R⁶, R¹¹ and R¹⁶ are independently selected from the group consisting of methyl, ethyl and isopropyl groups.

Preferably, in the borazine derivative not according to the invention, at least one substituent, preferably all the substituents, selected from the group of R¹⁹, R²⁰ and R²¹ are independently selected from the group consisting of hydrogen, and linear or branched saturated alkyl groups, preferably with 1 to 12 carbon atoms, more preferably with 1 to 6 carbon atoms, even more preferably with 1 to 3 carbon atoms. Exemplary linear or branched saturated alkyl groups for use herein include, but are not limited to, methyl, ethyl, n-propyl, iso-propyl, n-butyl, iso-butyl, tertio-butyl, pentyl, hexyl and dodecyl groups. More preferably, in the (borazine) derivative not according to the invention, at least one substituent, preferably all the substituents, selected from the group of R¹⁹, R²⁰ and R²¹ are independently selected from the group consisting of hydrogen and dodecyl groups.

Preferably, in the borazene or borazine derivatives, each of R¹ to R³ is independently selected from the group consisting of hydrogen, linear or branched saturated alkyl group, cycloalkyl group, aryl group and aralkyl group. More preferably, in the borazene or borazine derivatives, each of R¹ to R³ is independently selected from the group consisting of hydrogen, isopropyl, cyclohexyl and phenyl groups.

Preferably, in the borazene derivatives of the invention, R²⁸ is selected from the group consisting of hydrogen, linear or branched saturated alkyl group, cycloalkyl group, aryl group and aralkyl group. More preferably, in the borazene derivative of the invention, R²⁸ is selected from the group consisting of hydrogen, isopropyl, cyclohexyl and phenyl groups.

Preferably, in the borazene derivatives of the invention, X is selected from the group consisting of hydroxyl, alkoxy group, cycloalkyloxy group, aryloxy group, aralkyloxy group, amino group, alkylamino group, cycloalkylamino group, arylamino group and aralkylamino group; preferably from the group consisting of hydroxyl, alkylamino group, cycloalkylamino group, and arylamino group. More preferably, in the borazene derivative of the invention, X is selected from the group consisting of hydroxyl, cyclohexylamino group, benzylamino group and isopropylamino group.

According to one preferred aspect not according to the invention, the borazine derivative is according to formula (**II**), wherein R⁴, R⁶, R⁸, R⁹, R¹¹, R¹³, R¹⁴, R¹⁶ and R¹⁸ are methyl groups; and wherein R⁵, R⁷, R¹⁰, R¹², R¹⁵, R¹⁷ and R¹⁹ to R²⁷ are selected to be hydrogen. Accordingly, in one preferred aspect not according to the invention, the borazine derivative is represented by the following formula (**1**) :

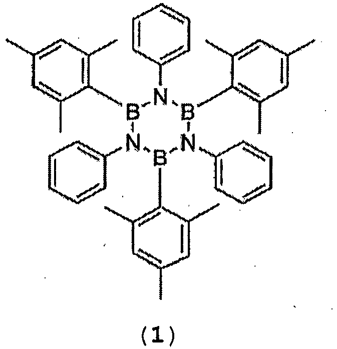

According to another preferred aspect not according to the invention, the borazine derivative is according to formula (**II**), wherein R⁴, R⁶, R⁸, R⁹, R¹¹, R¹³, R¹⁴, R¹⁶ and R¹⁸ are methyl groups; wherein R⁵, R⁷, R¹⁰, R¹², R¹⁵ and R¹⁷ and R²² to R²⁷ are selected to be hydrogen; and wherein R¹⁹, R²⁰, R²¹ are dodecyl groups. Accordingly, in one preferred aspect not according to the invention, the borazine derivative is represented by the following formula (**2**) :

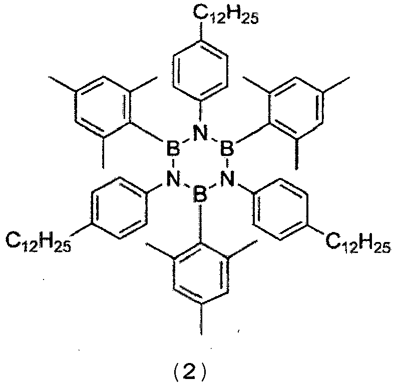

According to still another preferred aspect, the borazene derivative of the invention is according to formula (**III**), wherein R¹ and R² are cyclohexyl groups; wherein R⁴, R⁶, R⁸, R¹⁴, R¹⁶ and R¹⁸ are methyl groups; wherein R⁵, R⁷, R¹⁵, R¹⁷ and R²⁸ are selected to be hydrogen; and wherein X is selected to be hydroxyl group. Accordingly, in one preferred aspect, the borazene derivative of the invention is represented by the following formula (**3**):

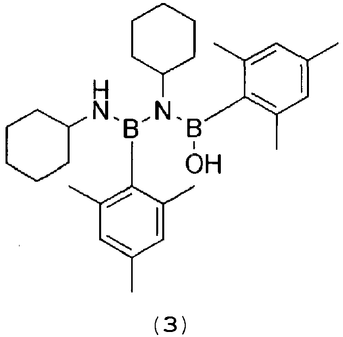

According to still another-preferred aspect, the borazene derivative of the invention is according to formula (**III**), wherein R¹ and R² are cyclohexyl groups; wherein R⁴, R⁶, R⁸, R¹⁴, R¹⁶ and R¹⁸ are methyl groups; wherein R⁵, R⁷, R¹⁵, R¹⁷ and R²⁸ are selected to be hydrogen; and wherein X is selected to be cyclohexylamino group. Accordingly, in one preferred aspect, the borazene derivative of the invention is represented by the following formula (**4**) :

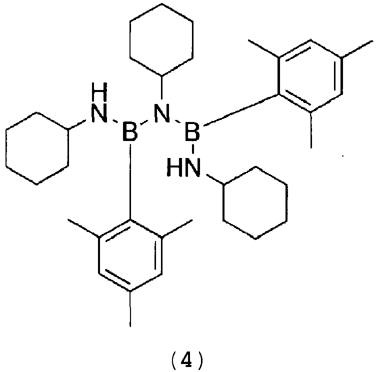

According to still another preferred aspect, the borazene derivative of the invention is according to formula (**III**), wherein R¹ and R² are benzyl groups; wherein R⁴, R⁶, R⁸, R¹⁴, R¹⁶ and R¹⁸ are isopropyl groups; wherein R⁵, R⁷, R¹⁵, R¹⁷ and R²⁸ are selected to be hydrogen; and wherein X is selected to be hydroxyl group. Accordingly, in one preferred aspect, the borazene derivative of the invention is represented by the following formula (**5**) :

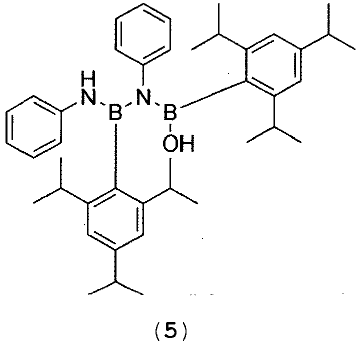

According to still another preferred aspect, the borazene derivative of the invention is according to formula (**III**), wherein R¹ and R² are benzyl groups; wherein R⁴, R⁶, R⁸, R¹⁴, R¹⁶ and R¹⁸ are isopropyl groups; wherein R⁵, R⁷, R¹⁵, R¹⁷ and R²⁸ are selected to be hydrogen; and wherein X is selected to be benzylamino group. Accordingly, in one preferred aspect, the borazene derivative of the invention is represented by the following formula (**6**) :

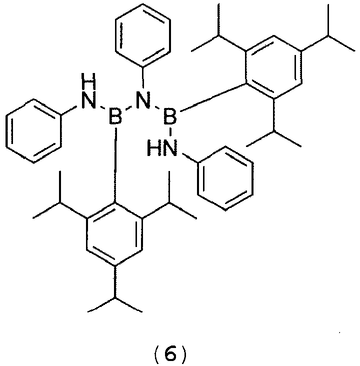

According to still another preferred aspect, the borazene derivative of the invention is according to formula (**III**), wherein R¹ and R² are isopropyl groups; wherein R⁴, R⁶, R⁸, R¹⁴, R¹⁶ and R¹⁸ are methyl groups; wherein R⁵, R⁷, R¹⁵, R ¹⁷ and R²⁸ are selected to be hydrogen; and wherein X is selected to be hydroxyl group. Accordingly, in one preferred aspect, the borazene derivative of the invention is represented by the following formula (**7**):

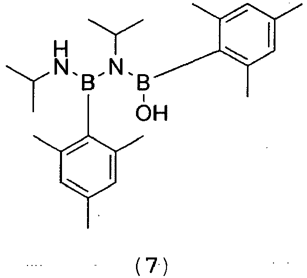

According to still another preferred aspect, the borazene derivative of the invention is according to formula (**III**), wherein R¹ and R² are isopropyl groups; wherein R⁴, R⁶, R⁸, R¹⁴, R¹⁶ and R¹⁸ are methyl groups; wherein R⁵, R⁷, R¹⁵, R¹⁷ and R²⁸ are selected to be hydrogen; and wherein X is selected to be isopropylamino group. Accordingly, in one preferred aspect, the borazene derivative of the invention is represented by the following formula (**8**):

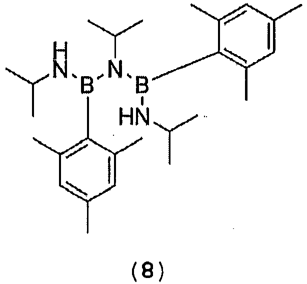

According to still another preferred aspect not according to the invention, the borazine derivative is according to formula (**II**), wherein R⁴, R⁵, R⁷, R⁸, R⁹, R¹⁰, R¹², R¹³, R¹⁹, R¹⁵, R¹⁷ and R¹⁸ are methyl groups; and wherein R⁶, R¹¹, R¹⁶ and R¹⁹ to R²⁷ are selected to be hydrogen. Accordingly, in one preferred aspect not according to the invention, the borazine derivative is represented by the following formula (**9**):

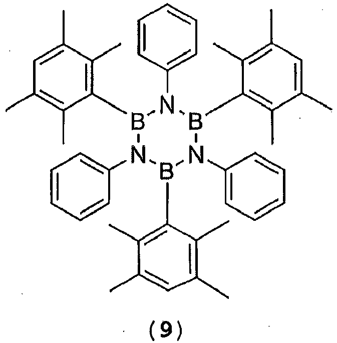

According to still another preferred aspect not according to the invention, the borazine derivative is represented by the following formula (**10**):

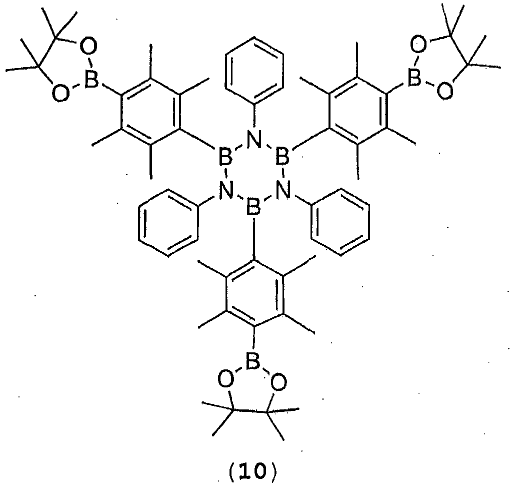

Advantageously, the borazine derivatives not according to the present invention may be easily synthesized according to standard and well established synthetic protocols. Suitable synthetic routes will be easily identified by those skilled in the art of synthetic organic chemistry.

One exemplary and suitable synthetic route to the borazine derivatives not according to the invention is described e.g. by Wakamiya et al. in J. Am. Chem. Soc. 2005, 127, 14859.

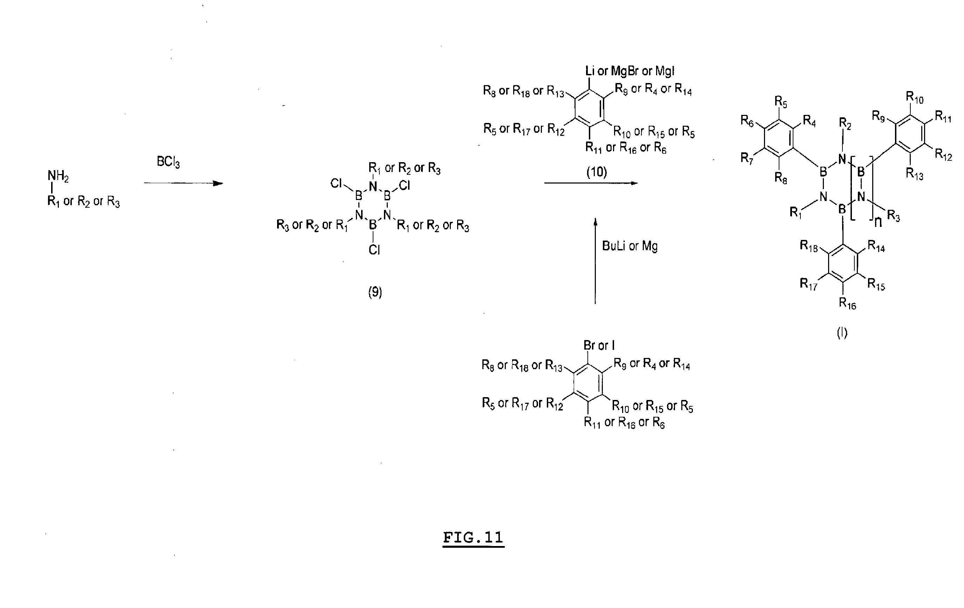

One general exemplary path for the synthesis of derivatives according to formula (**I**) involves the condensation reaction of primary amine derivative with boron trichloride, forming a borazole intermediate N,N,N"-trisubstituted-B,B,B"-trichloro (**9**) followed by substitution on the boron atoms of the chlorinated borazole by lithiate derivative (**10**) as described in **FIG.11**. Figure 11 describes the general synthetic strategy for the formation of derivatives according to formula (**I**), wherein: a)BCI₃, anhydrous toluene, reflux, 16h; b) BuLi, anhydrous THF, -78°C, 1h30; c) r.t., 3h.

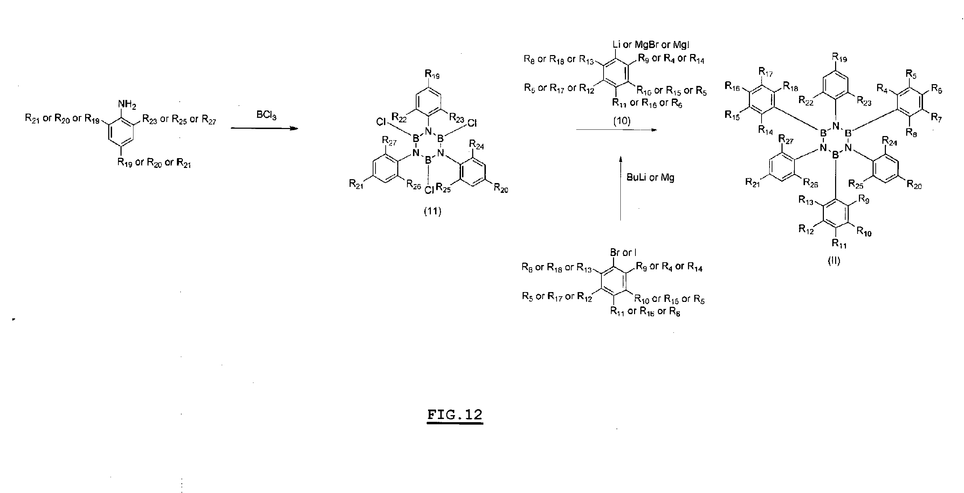

One general exemplary path for the synthesis of borazine derivatives according to formula (**II**) involves the condensation reaction of aniline derivative with boron trichloride, forming a borazole intermediate N,N,N"-substituted triphenyl-B,B,B"-trichloro (**11**) followed by substitution on the boron atoms of the chlorinated borazole by lithiate derivative (**10**) as described in **FIG. 12.** Figure 12 describes the general synthetic strategy for the formation of borazine derivatives according to formula (**II**), wherein: a) BCl3, anhydrous toluene, reflux, 16h; b) BuLi, anhydrous THF, -78°C, 1h30; c) r.t., 3h.

According to another aspect, the present invention relates to an electronic device comprising at least one layer comprising a borazene derivative as described above. The electronic device according to the present invention is preferably selected from the group consisting of electroluminescent and semiconductor devices.

In a preferred aspect, the electronic device of the invention is an electroluminescent device, preferably an OLED, wherein the layer is preferably the emissive layer. Alternatively, the layer comprising a borazene derivative of the invention may be any of other typical layers of electroluminescent layers such as e.g. hole-injection layer, hole-transporting layer, electron-injection layer and electron-transporting layer.

According to the preferred aspect wherein the electronic device of the invention is an electroluminescent device, such device comprises preferably at least one layer comprising a borazine derivative not according to the invention as described above.

In another preferred aspect, the electronic device of the invention is a semiconductor device. More preferably, the electronic device of the invention is a transistor.

According to the preferred aspect wherein the electronic device of the invention is a semiconductor device, preferably a transistor, such device comprises preferably a borazene derivative as described above.

According to still another aspect of the present invention, it is provided a method for the manufacture of an electronic device which comprises the step of including a borazene derivative, as described above, wherein the electronic device is preferably selected from the group consisting of electroluminescent and semiconductor devices.

Preferably, in the method of the present invention, the electronic device is an electroluminescent device, more preferably and OLED. Preferably still, in the method of the present invention the borazene derivative is included in the emissive layer of the OLED. Alternatively, the borazene derivative of the invention may be included in any of other typical layers of electroluminescent layers such as e.g. hole-injection layer, hole-transporting layer, electron-injection layer and electron-transporting layer.

According to the preferred aspect wherein the method of the invention is directed to the manufacture of an electroluminescent device, such method comprises preferably the step of including a borazine derivative not according to the invention as described above.

In another preferred aspect of the method of the present invention, the electronic device is a semiconductor device, more preferably a transistor. According to this preferred aspect, the method comprises preferably the step of including a borazene derivative as described above.

According to still another aspect, the present invention relates to the use of borazene derivatives as described above for the manufacture of an electronic device. Preferably, the borazene derivative of the invention is used for the manufacture of a device selected from the group consisting of electroluminescent and semiconductor devices.

In a preferred aspect, the borazene derivative of the invention is used for the manufacture of an OLED, wherein the borazene derivative is preferably used for the manufacture of the emissive layer of the OLED. Alternatively, borazene derivatives of the invention may be used for the manufacture of other typical layers of electroluminescent layers such as e.g. hole-injection layer, hole-transporting layer, electron-injection layer and electron-transporting layer.

According to the preferred aspect of the invention wherein the manufacture of an electroluminescent device is envisaged, it is preferably made use of borazine derivatives not according to the invention as described above.

In another preferred aspect, the borazene derivatives of the invention are used for the manufacture of a semiconductor device, preferably a transistor.

According to the alternatively preferred aspect of the invention wherein the manufacture of a semiconductor device, preferably a transistor, is envisaged, it is preferably made use of borazene derivatives as described above.

In still another aspect, the present invention is directed to an organic composition comprising borazene derivatives as above-described. Preferably, the organic composition is an ink composition suitable for use in a continuous printing process, more preferably in an ink jet printing process.

In the context of the present invention, it has been surprisingly found that borazene derivatives according to the invention exhibit excellent solubility in common organic solvents, which makes them suitable for the preparation of e.g. organic inks which can be in turn be used in the manufacture of e.g. OLEDs by e.g. deposition solution. Without being bound by theory, it is believed that the strong (improved) solubility of some of the borazine derivatives not according to the invention is due to the presence of substituents, such as e.g. alkyl chains on the corresponding phenyl rings.

### EXAMPLES

### Example 1 (useful for understanding the invention)

Detailed synthesis of borazine intermediate N,N',N"-triphenyl-B,B,B"-tri(2,4,6-trimethyl)phenyl borazine (**1**).
Reference: Yamagushi, JACS, 2005, page 14859.

In a dry 25ml Schlenk flask, anhydrous aniline (370mg, 4mmoles) is diluted with 8ml of anhydrous toluene. The solution is allowed to cool down to -5°C (ice-salt bath). Then boron trichloride, (5.2ml, 5.2mmoles, 1M solution in toluene) is added dropwise which yields to a white precipitate. The septum is changed for a dry condenser topped by a calcium chloride tube. The reaction mixture is heated up for 16h. After this period, the flask is cooled down and subject to three freeze-to-thaw cycle to remove the hydrogen chloride.

Preparation of the lithiate: in a dry 50ml Schlenk flask, bromomesitylene (876mg, 4.4mmoles) is diluted with 10ml of anhydrous THF. The solution is cooled down to -78°C and freshly titrated buthyl lithium (3.8ml, 5.2mmoles) is added dropwise. The flask is allowed to warm up to 0°C for 1h. The color changes from transparent to light yellow. The borazine is cannulated dropwise to the lithiate at 0 °C and allowed to react at room temperature. Aliquots are taken after 3h and 24h, the NMR analysis shows no changes between the two samples. After 24h, the reaction is quenched by 20ml of water. The aqueous layer is extracted three times with 20ml of ethyl acetate. The organic layer is dried over magnesium sulphate, filtered and the solvents removed with vacuum. The crude is purified by silica gel chromatography, ethyl acetate-cyclohexane (1:5) (Rf=0.5).

The compound crystallizes in:
a) Dichloromethane (r.t., slow evaporation, big needles)
b) Cyclohexane (r.t., slow evaporation, hexagon which brakes when they dry)
c) Pentane, hexane or methyl acetate (5°C, hexagon obtained with cyclohexane slowly convert into this more stable forms, several appearance, pyramid, parallelogram, etc).
¹H (400MHz, CDCl₃, 25°C): δ (ppm) 6.82-6.80 (d of d, 8Hz, 6H, H₂); 6.77-6.71 (m, 9H, H₃ and H₄); 6.32 (s, 6H, H₇); 2.22 (s, 18H, H₉) 1.97 (s, 9H, H₁₀) ¹³C (100MHz, CDCl₃, 25°C) δ (ppm) 146.4 (C₁) ; 137.3; 136.1; 127.0; 126.7; 126.2; 23.1 (C9) ; 21.1 (C₁₀).
¹¹B (100MHz, CDCl₃, 25°C) δ (ppm) 38-35 (w).
¹H (400MHz, C₆D₆, 25°C): δ (ppm) 7.16 (d, 6.8Hz, 6H, H₂); 6.78 (t, 8Hz, 6H, H₃), 6.58 (t, 7.6Hz, 3H, H₄); 6.47 HZ (s, 6H, H₇); 2.51 (s, 18H, H₉); 1.86 (s, 9H, H₁₀).
IR: Solid. KBr. (cm⁻¹) 3027 (CH aromatic); 2914; 2854 (CH alkyl); 1611; 1597; 1491; 1359 (B-N) 1308;
Mass spectrometry: C₄₅H₄₈N₃B₃, Theory: MM= 663.3157; Exact Mass= 663.4127.
UV: Solvent: acetonitrile. Absorption maxima: 259nm (ε= 6.4 10³) ; 265nm (ε= 11 10³); 271nm (ε= 9.7 10³), 217nm. Fluorescence: Solvent: acetonitrile. Excitation: 264nm. Emission: 305nm.

### Solubility:

| Solvent | Milligram/milliliter |
|---|---|
| Toluene | 45 |
| Ethyl acetate | 62 |
| Dichloromethane | 102 |
| Chloroform | 54 |

### Example 2 (useful for undesrtanding the invention)

Detailed synthesis of borazine intermediate N,N',N"-tri(4-dodecyl)phenyl-B,B,B"-tri(2,4,6-trimethyl) phenyl borazine (**2**).
Reference: Yamagushi, JACS, 2005, p14859

In a dry 25ml Schlenk flask, anhydrous 4-dodecylaniline (261.46mg, 1mmoles) is diluted with 8ml of anhydrous toluene. The solution is allowed to cool down to -5°C (ice-salt bath). Then boron trichloride (1.3ml, 1.3mmoles, 1M solution in toluene) is added dropwise which yields to a white precipitate. The septum is changed for a dry condenser topped by a calcium chloride tube. The reaction mixture is heated up for 18h. After this period the flask is cooled down and subject to three freeze-to-thaw cycle to remove the hydrogen chloride.

Preparation of the lithiate: in a dry 50ml Schlenk flask, bromomesitylene (219mg, 1.1mmoles) is diluted with 10ml of anhydrous THF. The solution is cooled down to -78°C and freshly titrated buthyl lithium (3.8ml, 5.2mmoles) is added dropwise. The flask is allowed to warm up to 0°C for 1h. The color changes from transparent to light yellow. The borazine is cannulated dropwise to the lithiate at 0°C and allowed to react at room temperature. After 15h the reaction was quenched by 20ml of water. The aqueous layer is extracted three times with 20ml of ethyl acetate. The organic layer is dried over magnesium sulphate, filtered and the solvents removed with vacuum. The crude is purified by silica gel chromatography, cyclohexane:dichloromethane (1:4) (Rf=0.2).
¹H (400MHz, CDCl₃, 25°C) δ (ppm) 6.66(d, 8Hz, 6H, *H₃*); 6.50 (d, 8Hz, 6H, *H₂*); 6.31 (s, 6H, *H₇);* 2.26 (t, 6.2Hz, 6H, Ph-*CH*₂-CH₂) 2.18 (s, 18H, H₉)*,* 1.97 (s 9H, *H₁₀*)*;* 1.32-1.25 (w, 19H, alkyl), 0.88 (t, 6.6Hz, CH₂-*CH*₃).
¹³C (100MHz, CDCl₃, 25°C) δ (ppm) 143.9 (C₁); 138.0; 137.3; 136.9; 135.7; 126.7 (C₃); 126. 6 (C₂), 126. 0 (C₇); 34.9 (Ph-*CH*₂-CH₂)*;* 32. 0; 31.0; 29. 8; 29. 7; 23. 1 (C₉); 23.0; 21. 1 (C₁₀); 14.2 (CH₂-*CH₃*)*.*
¹¹B (100MHz, CDCl₃, 25°C) δ (ppm) 38-35 (w).
IR: Solid. KBr. (cm⁻¹) 2925 (CH aromatic); 2853 (CH alkyl); 1611; 1509; 1438; 1361 (B-N) 1301; 847.
Mass spectrometry: C₈₁H₁₂₀N₃B₃, Theory: MM= 1168.2939; Exact Mass= 1167.9761
Solubility: The compound is an oil, which is miscible with toluene, ethyl acetate, dichloromethane, benzene and chloroform.

### Example 3

Detailed synthesis of borazene intermediate (**3**). In a dry 25ml Schlenk flask, anhydrous cyclohexylamine (991.76mg, 10mmoles) is diluted with 3ml of anhydrous toluene. The solution is allowed to cool down to -5°C (ice-salt bath). Then boron trichloride (12ml, 12mmoles, 1M solution in toluene) is added dropwise. The septum is changed for a dry condenser topped by a calcium chloride tube. The reaction mixture is heated up for 15h. After this period the flask is cooled down and subject to three freeze-to-thaw cycle to remove the hydrogen chloride.

Preparation of the lithiate: in a dry 100ml Schlenk flask, bromomesitylene (2,189mg, 11mmoles) is diluted with 60ml of anhydrous THF. The solution is cooled down to -78°C and freshly titrated buthyl lithium (13ml, 13mmoles) is added dropwise. The flask is allowed to warm up to 0°C for 1h. The color changes from transparent to light yellow. The borazene is cannulated dropwise to the lithiate at 0°C and allowed to react at room temperature. After 25h the reaction was quenched by 20ml of water. The aqueous layer is extracted three times with 40ml of ethyl acetate. The organic layer is dried over magnesium sulphate, filtered and the solvents removed with vacuum. The crude is purified by precipitation of cyclohexyamonium in acetonitrile.
¹H (400MHz, CDCl₃ 25°C) δ (ppm) (rotamer) 6.80-6.55 (s), 2.85 (m), 2.15 (s, methyls), 1.86 (m), 1.65 (m), 1.50 (m), 1.22 (m), 1.04 (m).
¹¹B (400MHz, CDCl₃, 25°C) δ (ppm) 36.2 (s), 30.7 (s).
¹³C (400MHz, CDCl₃, 25° C) δ (ppm) 138.5, 138.4, 137.8, 127.1, 127.1, 127.0, 126.8, 56.7, 34.6, 26.6, 25.8, 22.4, 22.2, 22.0, 21.2.
IR: Solid. KBr. (cm⁻¹) 3393(NH), 2927 (CH aromatic), 2853 (CH alkyl), 1609, 1486, 1356 (BN), 1283.
Mass spectrometry: C₃pH₄₆N₂OB₂, Theory: Calculated (MH⁺) = 473.3875; Exact Mass= 473.3853.
C₃₆H₅₇N₃B₂, Theory: Calculated= 553.4739 Exact Mass= 554.1. UV: Solvent: acetonitrile. Absorption maxima: 209nm Fluorescence: Solvent: acetonitrile. Excitation: 278nm. Emission: 318nm.
Solubility: The compound is an oil, which is miscible with toluene, ethyl acetate, dichloromethane, benzene, chloroform and acetonitrile.

### Example 4

Detailed synthesis of borazene intermediate (5). In a dry 25ml Schlenk flask, anhydrous aniline (335.26mg, 3.6mmoles) is diluted with 4ml of anhydrous toluene. The solution is allowed to cool down to -5°C (ice-salt bath). Then boron trichloride (4.7ml, 4.7mmoles, 1M solution in toluene) is added dropwise. The septum is changed for a dry condenser topped by a calcium chloride tube. The reaction mixture is heated up for 17h. After this period the flask is cooled down and subject to three freeze-to-thaw cycle to remove the hydrogen chloride.

Preparation of the lithiate: in a dry 50ml Schlenk flask, 1-bromo-2,4,6-triisopropylbenzene (1,230mg, 4mmoles) is diluted with 20ml of anhydrous THF. The solution is cooled down to -78°C and freshly titrated buthyl lithium (3.5ml, 4.3mmoles) is added dropwise. The flask is allowed to warm up to 0°C for 1h. The colour changes from transparent to light yellow. The borazene is cannulated dropwise to the lithiate at 0°C and allowed to react at room temperature. After 20h the reaction was quenched by 20ml of water. The aqueous layer is extracted three times with 40ml of ethyl acetate. The organic layer is dried over magnesium sulphate, filtered and the solvents removed with vacuum. The crude is purified by chromatography column so as to obtain a white solid. Eluent: cyclohexane:dichloromethane (1:1).
Crystal obtained in pentane. Spatial group: P21/n.
¹H (400MHz, CDCl₃ 25°C) δ (ppm) (rotamer) 7.20 (m), 7.12 (s), 7.07 (m), 6.90 (s), 6.84 (t), 6.71 (m), 6.64 (s), 6.58 (m), 6.13-6.07 (s), 5.32 (d), 5.2 (s), 3.18-2.88 (m), 1.31-1.09 (m).
¹¹B (400MHz, CDCl₃ 25°C) δ (ppm) 30.69.
¹³C (400MHz, CDCl₃ 25°C) δ (ppm) (rotamers) 151.1, 148.8, 148.0, 145.3, 143.4, 129.3, 129.1, 128.8, 128.5, 128.0, 125.7, 122.0, 121.6, 121.6, 119.4, 119.1, 118.8, 35.6, 35.3, 35.2, 35.0, 34.5, 34.1, 26.8, 25.3, 25.2, 24.7, 24.25, 24.2, 24.0, 23.8, 22.7.
IR: Solid. KBr. (cm⁻¹) 3373 (OH) 2959 (CH aromatic), 2869 (CH alkyl), 1517, 1462, 1361 (BN), 1312, 1196.
Mass spectrometry: C₄₂H₅₈N₂OB₂, Theory: Calculated= 628.4735; Exact Mass= 668.4735.
C₄₈H₆₃N₃OB₂, Theory: Calculated= 703.5208; Exact Mass= 703.5180.
UV: Solvent: acetonitrile. Absorption maxima: 209nm.
Fluorescence: Solvent: acetonitrile. Excitation: 278nm. Emission: 318nm.

### Example 5

Detailed synthesis of borazene intermediate (**7**). In a dry 25ml Schlenk flask, anhydrous isopropylamine (298mg, 5mmoles) is diluted with 2ml of anhydrous toluene. The solution is allowed to cool down to -5°C (ice-salt bath). Then boron trichloride (6ml, 6mmoles, 1M solution in toluene) is added dropwise. The septum is changed for a dry condenser topped by a calcium chloride tube. The reaction mixture is heated up for 16h. After this period the flask is cooled down and subject to three freeze-to-thaw cycle to remove the hydrogen chloride.

Preparation of the lithiate: in a dry 50ml Schlenk flask, bromomesitylene (1,094mg, 5.5mmoles) is diluted with 20ml of anhydrous THF. The solution is cooled down to -78°C and freshly titrated buthyl lithium (3ml, 6mmoles) is added dropwise. The flask is allowed to warm up to 0°C for 1h. The colour changes from transparent to light yellow. The borazene is cannulated dropwise to the lithiate at 0°C and allowed to react at room temperature. After 15h the reaction was quenched by 10ml of water. The aqueous layer is extracted three times with 20ml of ethyl acetate. The organic layer is dried over magnesium sulphate, filtered and the solvents removed with vacuum. The crude is purified by chromatography column so as to obtain a white solid. Eluent: cyclohexane:dichloromethane (1:1).
Crystal obtained in pentane. Spatial group: P21/n.
¹H (400MHz, CDCl₃, 25°C) δ (ppm) (rotamer) 6.76 (s), 6.75 (s), 3.70(m), 2.60 (m), 1.25-1.23 (m), 0.43 (m).
¹¹B (400MHz, CDCl₃, 25°C) δ (ppm) 34.38.
¹³C (400MHz, CDCl₃, 25°C) δ (ppm) (rotamers) 138.8, 138.6, 138.0, 127.5, 126.9, 50.1, 47.5, 43.7, 25.9, 23.9, 21.5, 21.2.
IR: Solid. KBr. (cm⁻¹) 3536 (OH), 3390 (NH) 2993 (CH aromatic), 2863 (CH alkyl), 1609, 1450, 1348 (BN), 1327, 1277.
Mass spectrometry: C₂₄H₃₈N₂OB₂, Theory: MM= 392.3170; Exact Mass= 392.3179.
UV: Solvent: acetonitrile. Absorption maxima: 208nm. Fluorescence: Solvent: acetonitrile. Excitation: 278nm. Emission: 302nm.

## Claims

1. A derivative having the formula (**III**): 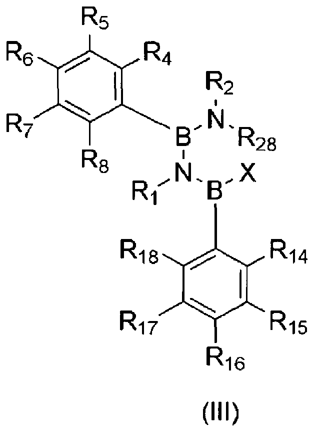 wherein the substituents R¹, R², R⁴ to R⁸, and R¹⁴ to R¹⁸ are the same or different from each other;
wherein each of R¹, R², R⁴ to R⁸, and R¹⁴ to R¹⁸ is independently selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbonyl group; carbamoyl group, arlyoxycarbonyl group, phenoxycarbonyl group, alkoxycarbonyl group and halogen;
wherein R⁴, R⁸, R¹⁴ and R¹⁸ cannot simultaneously be selected to be hydrogen;
R⁴ to R⁸ and R¹⁴ to R¹⁸ cannot simultaneously be selected to be fluorine;
wherein R¹ and R² cannot simultaneously be selected to be methyl;
wherein R²⁸ is selected from the group consisting of: hydrogen; linear or branched saturated alkyl group; linear or branched unsaturated alkyl group; cycloalkyl group; aryl group; aralkyl group; heteroaryl group; acyl group; hydroxyl; alkoxy group; aryloxy group; acyloxy group; amino group; alkylamino group; arylamino group; acylamino group; cyano group; carboxyl group; thio group; aminocarbobyl group; carbamoyl group, arlyoxycarbonykl group, phenoxycarbonyl group, alkoxycarbonyl group and halogen;
wherein X is selected from the group consisting of: hydroxyl; alkoxy group; cycloalkyloxy group; aryloxy group; aralkyloxy group; acyloxy group; amino group; alkylamino group; cycloalkylamino group; dialkylamino group; arylamino group; aralkylamino group; diarylamino group; acylamino group; and
wherein at least one substituent selected from the group of R⁶ and R¹⁶ is independently selected from the group consisting of linear or branched saturated alkyl groups, preferably with 1 to 6 carbon atoms, more preferably with 1 to 4 carbon atoms, even more preferably with 1 to 3 carbon atoms.

2. A derivative according to any of the preceding claims, wherein at least two substituents, preferably all the substituents selected from the group of R⁴, R⁸, R¹⁴ and R¹⁸ are independently selected from the group consisting of linear or branched saturated alkyl groups, preferably with 1 to 6 carbon atoms, more preferably with 1 to 4 carbon atoms, even more preferably with 1 to 3 carbon atoms.

3. A derivative according to claim 1 or 2, wherein each of R¹, R² and R²⁸ is independently selected from the group consisting of hydrogen, linear or branched saturated alkyl group, cycloalkyl group, aryl group and aralkyl group.

4. A derivative according to any of claims 1 to 3, wherein X is selected from the group consisting of hydroxyl, alkoxy group, cycloalkyloxy group, aryloxy group, aralkyloxy group, amino group, alkylamino group, cycloalkylamino group, arylamino group and aralkylamino group; preferably from the group consisting of hydroxyl, alkylamino group, cycloalkylamino group, and arylamino group.

5. A derivative according to any of claims 1 to 4, able to emit in the UV region with a quantum yield above 0.05, preferably above 0.3, more preferably above 0.4, even more preferably above 0.5, most preferably above 0.6.

6. A method for the manufacture of an electronic device comprising the step of including a derivative according to any of claims 1 to 5, wherein the electronic device is preferably selected from the group consisting of electroluminescent and semiconductor devices.

7. A method according to claim 6, wherein the electronic device is an OLED, and wherein the derivative is preferably included in the emissive layer of said OLED.

8. A method according to claim 6, wherein the electronic device is a semiconductor device, preferably a transistor.

9. Use of a derivative according to any of claims 1 to 5 for the manufacture of an electronic device, preferably for the manufacture of a device selected from the group consisting of electroluminescent and semiconductor devices.

10. Use according to claim 9, wherein the electronic device is an OLED, and wherein the derivative is preferably used for the manufacture of the emissive layer of said OLED.

11. Use according to claim 9, wherein the electronic device is a semiconductor device, preferably a transistor.

12. Electronic device comprising at least one layer comprising a borazene derivative according to any of claims 1 to 5, wherein the electronic device is preferably selected from the group consisting of electroluminescent and semiconductor devices.

13. Electronic device according to claim 12, said electronic device being an OLED wherein said layer is preferably the emissive layer.

14. Electronic device according to claim 12, said electronic device being a semiconductor device, preferably a transistor.

## Patentansprüche

1. Derivat der Formel (III): 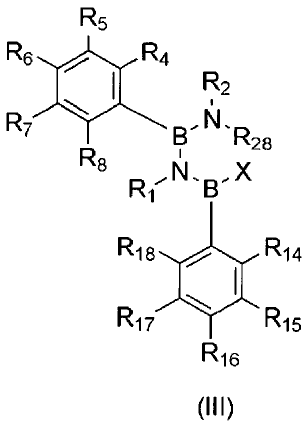 wobei die Substituenten R¹, R², R⁴ - R⁸ und R¹⁴ - R¹⁸ gleich oder unterschiedlich sind; wobei R¹, R², R⁴ - R⁸ und R¹⁴ - R¹⁸ jeweils unabhängig voneinander aus der nachfolgenden Gruppe gewählt sind: Wasserstoff; lineare oder verzweigte, gesättigte Alkylgruppe; lineare oder verzweigte, ungesättigte Alkylgruppe; Cycloalkylgruppe; Arylgruppe; Aralkylgruppe; Heteroarylgruppe; Acylgruppe; Hydroxyl; Alkoxygruppe; Aryloxygruppe; Acyloxygruppe; Aminogruppe; Alkylaminogruppe; Arylaminogruppe; Acylaminogruppe; Cyanogruppe; Carboxylgruppe; Thiogruppe; Aminocarbonylgruppe; Carbamoylgruppe, Arlyoxycarbonylgruppe, Phenoxycarbonylgruppe, Alkoxycarbonylgruppe und Halogen; wobei R⁴, R⁸, R¹⁴ und R¹⁸ nicht gleichzeitig als Wasserstoff gewählt sein können;
R⁴ - R⁸ und R¹⁴ - R¹⁸ nicht gleichzeitig als Fluor gewählt sein können;
wobei R¹ und R² nicht gleichzeitig als Methyl gewählt sein können;
wobei R²⁸ aus der nachfolgenden Gruppe gewählt ist: Wasserstoff; lineare oder verzweigte gesättigte Alkylgruppe; lineare oder verzweigte ungesättigte Alkylgruppe; Cycloalkylgruppe; Arylgruppe; Aralkylgruppe; Heteroarylgruppe; Acylgruppe; Hydroxyl; Alkoxygruppe; Aryloxygruppe; Acyloxygruppe; Aminogruppe; Alkylaminogruppe; Arylaminogruppe; Acylaminogruppe; Cyanogruppe; Carboxylgruppe; Thiogruppe; Aminocarbobylgruppe; Carbamoylgruppe, Arlyoxycarbonyklgruppe, Phenoxycarbonylgruppe, Alkoxycarbonylgruppe und Halogen;
wobei X aus der nachfolgenden Gruppe gewählt ist: Hydroxyl; Alkoxygruppe; Cycloalkyloxygruppe; Aryloxygruppe; Aralkyloxygruppe; Acyloxygruppe; Aminogruppe; Alkylaminogruppe; Cycloalkylaminogruppe; Dialkylaminogruppe; Arylaminogruppe; Aralkylaminogruppe; Diarylaminogruppe; Acylaminogruppe; und wobei mindestens ein Substituent aus der Gruppe von R⁶ und R¹⁶ jeweils unabhängig voneinander aus der nachfolgenden Gruppe gewählt ist: lineare oder verzweigte gesättigte Alkylgruppen, vorzugsweise mit 1 bis 6 Kohlenstoffatomen, insbesondere 1 bis 4 Kohlenstoffatomen, besonders bevorzugt 1 bis 3 Kohlenstoffatomen.

2. Derivat nach einem der vorstehenden Ansprüche, wobei mindestens zwei Substituenten, vorzugsweise alle Substituenten aus der Gruppe R⁴, R⁸, R¹⁴ und R¹⁸, jeweils unabhängig voneinander aus der nachfolgenden Gruppe gewählt sind: lineare oder verzweigte gesättigte Alkylgruppen, vorzugsweise mit 1 bis 6 Kohlenstoffatomen, insbesondere 1 bis 4 Kohlenstoffatomen, besonders bevorzugt 1 bis 3 Kohlenstoffatomen.

3. Derivat nach Anspruch 1 oder 2, wobei jedes von R¹, R² und R²⁸ jeweils unabhängig voneinander aus der nachfolgenden Gruppe gewählt ist: Wasserstoff, lineare oder verzweigte gesättigte Alkylgruppe, Cycloalkylgruppe, Arylgruppe und Aralkylgruppe.

4. Derivat nach einem der Ansprüche 1 bis 3, wobei X aus der nachfolgenden Gruppe gewählt ist: Hydroxyl, Alkoxygruppe, Cycloalkyloxygruppe, Aryloxygruppe, Aralkyloxygruppe, Aminogruppe, Alkylaminogruppe, Cycloalkylaminogruppe, Arylaminogruppe und Aralkylaminogruppe, vorzugsweise gewählt aus der nachfolgenden Gruppe: Hydroxyl, Alkylaminogruppe, Cycloalkylaminogruppe und Arylaminogruppe.

5. Derivat nach einem der Ansprüche 1 - 4, das im UV-Bereich mit einer Quantenausbeute von mehr als 0,05, insbesondere mehr als 0,3, vorzugsweise mehr als 0,4, besonders bevorzugt mehr als 0,5 und ganz besonders bevorzugt mehr als 0,6 emittieren kann.

6. Verfahren zur Herstellung einer elektronischen Vorrichtung, umfassend den Schritt der Aufnahme eines Derivats nach einem der Ansprüche 1 bis 5, wobei die elektronische Vorrichtung vorzugsweise aus der Gruppe der elektrolumineszenten und Halbleitervorrichtungen gewählt ist.

7. Verfahren nach Anspruch 6, wobei die elektronische Vorrichtung eine OLED ist und wobei das Derivat vorzugsweise in der emissiven Schicht der OLED enthalten ist.

8. Verfahren nach Anspruch 6, wobei die elektronische Vorrichtung eine Halbleitervorrichtung, vorzugsweise ein Transistor, ist.

9. Einsatz eines Derivats nach einem der Ansprüche 1 bis 5 zur Herstellung einer elektronischen Vorrichtung, vorzugsweise zur Herstellung einer Vorrichtung, die aus der Gruppe der elektrolumineszenten und Halbleitervorrichtungen gewählt ist.

10. Einsatz nach Anspruch 9, wobei die elektronische Vorrichtung eine OLED ist und wobei das Derivat vorzugsweise zur Herstellung der emissiven Schicht der OLED eingesetzt wird.

11. Einsatz nach Anspruch 9, wobei die elektronische Vorrichtung eine Halbleitervorrichtung, vorzugsweise ein Transistor, ist.

12. Elektronische Vorrichtung, umfassend mindestens eine ein Borazenderivat nach einem der Ansprüche 1 bis 5 umfassende Schicht, wobei die elektronische Vorrichtung vorzugsweise aus der Gruppe der elektrolumineszenten und Halbleitervorrichtungen gewählt ist.

13. Elektronische Vorrichtung nach Anspruch 12, wobei die elektronische Vorrichtung eine OLED ist und wobei die Schicht vorzugsweise die emissive Schicht ist.

14. Elektronische Vorrichtung nach Anspruch 12, wobei die elektronische Vorrichtung eine Halbleitervorrichtung, vorzugsweise ein Transistor, ist.

## Revendications

1. Dérivé répondant à la formule (III) : 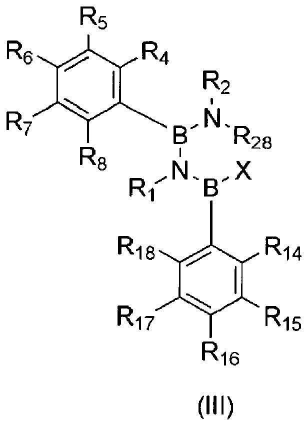 dans laquelle les substituants R¹, R², R⁴ à R⁸, et R¹⁴ à R¹⁸ sont identiques ou différents les uns des autres ;
dans laquelle chacun de R¹, R², R⁴ à R⁸, et R¹⁴ à R¹⁸ est indépendamment choisi dans le groupe constitué de : l'hydrogène ; un groupe alkyle saturé, linéaire ou ramifié ; un groupe alkyle insaturé, linéaire ou ramifié ; un groupe cycloalkyle ; un groupe aryle ; un groupe aralkyle ; un groupe hétéroaryle ; un groupe acyle ; un groupe hydroxyle ; un groupe alcoxy ; un groupe aryloxy ; un groupe acyloxy ; un groupe amino ; un groupe alkylamino ; un groupe arylamino ; un groupe acylamino ; un groupe cyano ; un groupe carboxyle ; un groupe thio ; un groupe aminocarbonyle ; un groupe carbamoyle, un groupe aryloxycarbonyle, un groupe phénoxycarbonyle, un groupe alcoxycarbonyle et l'halogène ;
dans laquelle R⁴, R⁸, R¹⁴ et R¹⁸ ne peuvent pas simultanément être choisis comme étant un atome d'hydrogène ;
R⁴ à R⁸ et R¹⁴ à R¹⁸ ne peuvent pas simultanément être choisis comme étant du fluor ;
dans laquelle R¹ et R² ne peuvent pas simultanément être choisis comme étant du méthyle ;
dans laquelle R²⁸ est choisi dans le groupe constitué de : l'hydrogène ; un groupe alkyle saturé, linéaire ou ramifié ; un groupe alkyle insaturé, linéaire ou ramifié ; un groupe cycloalkyle ; un groupe aryle ; un groupe aralkyle ; un groupe hétéroaryle ; un groupe acyle ; un groupe hydroxyle ; un groupe alcoxy ; un groupe aryloxy ; un groupe acyloxy ; un groupe amino ; un groupe alkylamino ; un groupe arylamino ; un groupe acylamino ; un groupe cyano ; un groupe carboxyle ; un groupe thio ; un groupe aminocarbonyle ; un groupe carbamoyle, un groupe aryloxycarbonyle, un groupe phénoxycarbonyle, un groupe alcoxycarbonyle et l'halogène ;
dans laquelle X est choisi dans le groupe constitué de : 1"hydroxyle ; un groupe alcoxy ; un groupe cycloalkyloxy ; un groupe aryloxy ; un groupe aralkyloxy ; un groupe acyloxy ; un groupe amino ; un groupe alkylamino ; un groupe cycloalkylamino ; un groupe dialkylamino ; un groupe arylamino ; un groupe aralkylamino ; un groupe diarylamino ; un groupe acylamino ; et
dans laquelle au moins un substituant choisi dans le groupe de R⁶ et R¹⁶ est indépendamment choisi dans le groupe constitué des groupes alkyles saturés, linéaires ou ramifiés, comportant de préférence de 1 à 6 atomes de carbone, comportant plus préférablement de 1 à 4 atomes de carbone, comportant encore plus préférablement de 1 à 3 atomes de carbone.

2. Dérivé selon l'une quelconque des revendications précédentes, dans lequel au moins deux substituants, de préférence tous les substituants choisis dans le groupe de R⁴, R⁸, R¹⁴ et R¹⁸, sont indépendamment choisis dans le groupe constitué des groupes alkyles saturés, linéaires ou ramifiés, comportant de préférence de 1 à 6 atomes de carbone, comportant plus préférablement de 1 à 4 atomes de carbone, comportant encore plus préférablement de 1 à 3 atomes de carbone.

3. Dérivé selon la revendication 1 ou 2, dans lequel chacun de R¹, R² et R²⁸ est indépendamment choisi dans le groupe constitué de l'hydrogène, d'un groupe alkyle saturé, linéaire ou ramifié, d'un groupe cycloalkyle, d'un groupe aryle et d'un groupe aralkyle.

4. Dérivé selon l'une quelconque des revendications 1 à 3, dans lequel X est choisi dans le groupe constitué d'un groupe hydroxyle, d'un groupe alcoxy, d'un groupe cycloalkyloxy, d'un groupe aryloxy, d'un groupe aralkyloxy, d'un groupe amino, d'un groupe alkylamino, d'un groupe cycloalkylamino, d'un groupe arylamino et d'un groupe aralkylamino ; de préférence dans le groupe constitué de l' hydroxyle, d'un groupe alkylamino, d'un groupe cycloalkylamino et d'un groupe arylamino.

5. Dérivé selon l'une quelconque des revendications 1 à 4, capable d'émettre dans la région UV avec un rendement quantique supérieur à 0,05, de préférence supérieur à 0,3, plus préférablement supérieur à 0,4, encore plus préférablement supérieur à 0,5, de manière préférée entre toutes supérieur à 0,6.

6. Procédé de fabrication d'un dispositif électronique comprenant l'étape consistant à inclure un dérivé selon l'une quelconque des revendications 1 à 5, dans lequel le dispositif électronique est de préférence choisi dans le groupe constitué des dispositifs électroluminescents et semiconducteurs.

7. Procédé selon la revendication 6, dans lequel le dispositif électronique est une diode électroluminescente organique (OLED), et dans lequel le dérivé est de préférence inclus dans la couche émissive de ladite diode électroluminescente organique.

8. Procédé selon la revendication 6, dans lequel le dispositif électronique est un dispositif semiconducteur, de préférence un transistor.

9. Utilisation d'un dérivé selon l'une quelconque des revendications 1 à 5 pour la fabrication d'un dispositif électronique, de préférence pour la fabrication d'un dispositif choisi dans le groupe constitué des dispositifs électroluminescents et semiconducteurs.

10. Utilisation selon la revendication 9, dans laquelle le dispositif électronique est une diode électroluminescente organique, et dans laquelle le dérivé est de préférence utilisé pour la fabrication de la couche émissive de ladite diode électroluminescente organique.

11. Utilisation selon la revendication 9, dans laquelle le dispositif électronique est un dispositif semiconducteur, de préférence un transistor.

12. Dispositif électronique comprenant au moins une couche comprenant un dérivé de borazène selon l'une quelconque des revendications 1 à 5, dans lequel le dispositif électronique est de préférence choisi dans le groupe constitué des dispositifs électroluminescents et semiconducteurs.

13. Dispositif électronique selon la revendication 12, ledit dispositif électronique étant une diode électroluminescente organique dans laquelle ladite couche est de préférence la couche émissive.

14. Dispositif électronique selon la revendication 12, ledit dispositif électronique étant un dispositif semiconducteur, de préférence un transistor.
